(19) **Europäisches Patentamt / European Patent Office / Office européen des brevets**

(11) **EP 4 772 857 A1**

(12) # EUROPEAN PATENT APPLICATION
published in accordance with Art. 153(4) EPC

(43) Date of publication:
08.07.2026 Bulletin 2026/28

(21) Application number: 24891029.1

(22) Date of filing: 06.08.2024

(51) International Patent Classification (IPC):
*G01N 15/1434* (2024.01)   *G01N 15/1429* (2024.01)
*G01N 21/05* (2006.01)   *G01N 21/49* (2006.01)
*G01N 21/64* (2006.01)   *H01S 5/02255* (2021.01)
*H01S 5/11* (2021.01)   *H01S 5/183* (2006.01)
*H01S 5/185* (2021.01)

(52) Cooperative Patent Classification (CPC):
**G01N 15/1429; G01N 15/1434; G01N 21/05;
G01N 21/49; G01N 21/64; H01S 5/02255;
H01S 5/11; H01S 5/183; H01S 5/185**

(86) International application number:
**PCT/JP2024/028106**

(87) International publication number:
**WO 2025/104985 (22.05.2025 Gazette 2025/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 13.11.2023   JP 2023192945

(71) Applicant: **Hamamatsu Photonics K.K.
Hamamatsu-shi, Shizuoka 435-8558 (JP)**

(72) Inventors:
• **KUMON, Hiroki**
  **Hamamatsu-shi, Shizuoka 435-8558 (JP)**
• **HIROSE, Kazuyoshi**
  **Hamamatsu-shi, Shizuoka 435-8558 (JP)**
• **KATSUMATA, Masakazu**
  **Hamamatsu-shi, Shizuoka 435-8558 (JP)**
• **HIRANO, Tomohiko**
  **Hamamatsu-shi, Shizuoka 435-8558 (JP)**

(74) Representative: **Grünecker Patent- und
Rechtsanwälte
PartG mbB
Leopoldstraße 4
80802 München (DE)**

(54) **LASER MEASUREMENT DEVICE AND LASER MEASUREMENT METHOD**

(57)     A laser measurement device includes a flow cell including a sample flow path through which a fluid containing a sample to be measured passes, a surface-emitting laser that emits laser light having a beam pattern in which at least two bright parts are arranged with a dark part interposed therebetween along a flow direction of the fluid toward the sample flow path, and a photodetector that detects emitted light emitted from the sample when the sample passes through a region where the beam pattern is formed in the sample flow path.

EP 4 772 857 A1

# *Fig.1*

**Description**

**Technical Field**

The present disclosure relates to a laser measurement device and a laser measurement method.

**Background Art**

Patent Literature 1 discloses a method of forming a region of a striped pattern in a sample flow path of a flow cell by irradiating the flow cell (flow path device) with two laser beams having optical axes different from each other, receiving scattered light or fluorescence emitted from a particle passing through the region of the striped pattern by a sensor, and measuring the size of the particle based on an output of the sensor.

**Citation List**

**Patent Literature**

[Patent Literature 1] Japanese Unexamined Patent Application Publication No. 2022-77967

[Patent Literature 2] Japanese Unexamined Patent Application Publication No. 2022-154929

**Non Patent Literature**

[Non-Patent Literature 1] Y. Kurosaka et al., "Effects of non-lasing band in two-dimensional photonic-crystal lasers clarified using omnidirectional band structure," Opt. Express 20, 21773-21783 (2012)

**Summary of Invention**

**Technical Problem**

In the above method, a width of the striped pattern (an interval between adjacent stripes) functions as a graduation (scale) for size measurement. Therefore, in order to accurately measure the size of the particle by the above method, the width of the striped pattern must be adjusted with high precision. However, in the above method, since the striped pattern is formed using two laser beams having optical axes different from each other, if the optical axis of each laser beam shifts even slightly, the width of the striped pattern changes. Therefore, in order to obtain a highly precise striped pattern, a sophisticated and complicated alignment operation of the light source or the above-described optical member is required to position the two laser beams (for example, two laser beams emitted from each of two light sources, or two laser beams formed by splitting a laser beam from one light source with an optical member such as a beam splitter) with high precision. Further, if the optical axis of the laser beam shifts even slightly due to vibration or the like generated during measurement, there is a possibility that the size of the particle cannot be calculated accurately.

Therefore, an object of an aspect of the present disclosure is to provide a laser measurement device and a laser measurement method capable of forming a beam pattern suitable for particle measurement using a flow path device with high precision and ease.

**Solution to Problem**

The present disclosure includes laser measurement devices of the following [1] to [18] and a laser measurement method of [19].

[1] A laser measurement device including: a flow path device including a sample flow path through which a fluid containing a particle to be measured passes; a light source that emits laser light toward the sample flow path, wherein the laser light has a beam pattern in which at least two bright parts are arranged with a dark part interposed therebetween along a flow direction of the fluid; and a sensor that detects emitted light emitted from the particle when the particle passes through a region where the beam pattern is formed in the sample flow path.

In the above laser measurement device, a beam pattern in which bright parts and dark parts are alternately arranged along the flow direction of the flow path device is formed in the sample flow path of the flow path device. Particle measurement (for example, measurement of the size of the particle, etc.) can be suitably performed based on emitted light emitted from the particle to be measured when the particle is caused to pass through the region where such a beam pattern is formed. Furthermore, according to the above laser measurement device, by using a single light source configured to form the beam pattern in advance, the beam pattern can be formed with high precision and ease. That is, in order to form the beam pattern, it is not necessary to perform sophisticated and complicated alignment adjustment of a plurality of light sources (that is, optical axes of laser beams emitted from respective light sources) or an optical member such as a beam splitter for splitting one laser beam emitted from one light source into two laser beams. As described above, according to the above laser measurement device, a beam pattern suitable for particle measurement using a flow path device can be formed with high precision and ease.

[2] The laser measurement device according to [1], wherein the light source has a surface-emitting laser configured to include: a light emitting unit; and a phase modulation layer optically coupled to the light emitting unit and including a base layer and a plurality of different refractive index regions having a refractive index different from that of the base layer.

According to the configuration of [2] above, by using the surface-emitting laser having the phase modulation layer as the light source, the above-described beam pattern can be suitably and easily formed in the sample flow path.

[3] The laser measurement device according to [2], wherein a center of gravity of each of the plurality of different refractive index regions is arranged at a relative position according to a phase distribution corresponding to the beam pattern with respect to each of a plurality of lattice points arranged periodically.

According to the configuration of [3] above, the above-described beam pattern can be suitably and easily formed in the sample flow path by the surface-emitting laser while making a slit member described later unnecessary.

[4] The laser measurement device according to [2], wherein the phase modulation layer is a photonic crystal layer in which the plurality of different refractive index regions are arranged periodically, and the light source further has a slit member that forms the laser light having the beam pattern by passing light emitted from the surface-emitting laser.

[5] The laser measurement device according to [1], wherein the light source has: a vertical cavity surface-emitting laser; and a slit member that forms the laser light having the beam pattern by passing light emitted from the surface-emitting laser.

According to the configuration of [4] or [5] above, the above-described beam pattern can be suitably and easily formed in the sample flow path by a combination of the surface-emitting laser and the slit member.

[6] The laser measurement device according to any one of [1] to [5], wherein the light source is fixed to a side wall of the flow path device.

According to the configuration of [6] above, attenuation of the laser light outside the flow path device can be suppressed. Further, positioning of the light source with respect to the flow path device can be facilitated, and the laser measurement device (module) can be miniaturized.

[7] The laser measurement device according to any one of [1] to [6], wherein the light source forms a striped beam pattern in which a plurality of the bright parts extending in a direction intersecting the flow direction are arranged along the flow direction.

According to the configuration of [7] above, it becomes possible to determine the size of the particle based on amplitude modulation of the emitted light detected by the sensor.

[8] The laser measurement device according to [7], wherein the light source has a surface-emitting laser configured to include a light emitting unit and a phase modulation layer optically coupled to the light emitting unit and including a base layer and a plurality of different refractive index regions having a refractive index different from that of the base layer, and the surface-emitting laser forms the striped beam pattern by causing lights emitted from respective ones of a plurality of regions different from each other in an in-plane direction of a light emission surface of the surface-emitting laser to interfere with each other.

According to the configuration of [8] above, a fine striped beam pattern (that is, a pattern with a minute pitch between the plurality of bright parts) can be formed with high precision in a space relatively close to the light emission surface of the surface-emitting laser. This makes it possible to suitably perform measurement of the size of minute particles such as cells while achieving miniaturization of the laser measurement device (module) by arranging the surface-emitting laser close to the flow path device.

[9] The laser measurement device according to any one of [1] to [8], wherein the light source includes a plurality of light source units arranged along the flow direction.

[10] The laser measurement device according to any one of [1] to [8], wherein the light source includes a plurality of light source units arranged along a direction intersecting the flow direction.

According to the configuration of [9] or [10] above, by combining beam patterns of each of the plurality of light source units, a beam pattern capable of performing more advanced particle measurement than particle measurement possible with a beam pattern of a single light source unit can be formed in the flow path device. According to the configuration of [9] above, by arranging the plurality of light source units along the flow direction, a mounting surface of the light source units with respect to the flow path device can be made common, so that the laser measurement device (module) can be made compact. According to the configuration of [10] above, by distributing and arranging the plurality of light source units around the sample flow path, the degree of freedom in arrangement of the light source units can be improved.

[11] The laser measurement device according to [9] or [10], wherein each of the plurality of light source units is configured to form, in the sample flow path, a striped beam pattern in which a plurality of the bright parts extending in a direction intersecting the flow direction are arranged at predetermined intervals along the flow direction, and in a passing region through which the particle passes in the sample flow path, the beam patterns of each of the plurality of light source units are arranged so as not to overlap each other.

According to the configuration of [11] above, by selecting two or more light source units that emit laser light from among the plurality of light source units, an interval (pitch) between the bright parts formed in the passing region can be easily and appropriately adjusted according to a size range of the particle to be measured.

[12] The laser measurement device according to [9] or [10], wherein the plurality of light source units form a first bright part having a first intensity of brightness in a region of a first range in a first direction intersecting the flow direction, and form a second bright part having a second intensity of brightness different from the first intensity in a region of a second range different from the first range in the first direction.

According to the configuration of [12] above, based on the intensity of the emitted light detected by the sensor, it becomes possible to identify a region (that is, the region of the first range or the region of the second range) through which the particle to be measured has passed in the sample flow path.

[13] The laser measurement device according to any one of [1] to [12], wherein the light source includes a first light source unit that emits the laser light of a first wavelength, and a second light source unit that emits the laser light of a second wavelength different from the first wavelength, and the sensor detects a first signal corresponding to first emitted light emitted in response to the particle being irradiated with the laser light of the first wavelength, and a second signal corresponding to second emitted light emitted in response to the particle being irradiated with the laser light of the second wavelength.

According to the configuration of [13] above, more advanced particle measurement can be performed based on measurement results corresponding to each of a plurality of wavelengths different from each other.

[14] The laser measurement device according to [13], wherein the first light source unit forms a striped beam pattern in which a plurality of the bright parts extending in a direction intersecting the flow direction are arranged at a first interval along the flow direction, and the second light source unit forms a striped beam pattern in which a plurality of the bright parts extending in a direction intersecting the flow direction are arranged at a second interval different from the first interval along the flow direction.

According to the configuration of [14] above, by making the pitch between the bright parts different for each wavelength, when particles to be measured have size ranges different from each other, it becomes possible to perform measurement of particle sizes corresponding to each range based on the measurement result of each wavelength (that is, the measurement result of the first signal or the measurement result of the second signal).

[15] The laser measurement device according to [13], wherein a first beam pattern formed by the first light source unit and a second beam pattern formed by the second light source unit have the same shape, and are arranged at positions shifted from each other along the flow direction.

According to the configuration of [15] above, based on a time lag between a waveform corresponding to the measurement result of the first wavelength (measurement result of the first signal) and a waveform corresponding to the measurement result of the second wavelength (measurement result of the second signal), and a positional shift amount between the first beam pattern and the second beam pattern, the velocity (flow velocity) of the particle in the sample flow path can be measured easily and with high precision.

[16] The laser measurement device according to [13], wherein a pattern shape of a first beam pattern formed by the first light source unit is different from a pattern shape of a second beam pattern formed by the second light source unit.

According to the configuration of [16] above, since measurement results (time waveforms) corresponding to different pattern shapes for each wavelength can be obtained, it becomes possible to perform more advanced particle measurement (waveform analysis).

[17] The laser measurement device according to [13], wherein the first light source unit forms a striped beam pattern in which a plurality of the bright parts extending in a first direction intersecting the flow direction are arranged along the flow direction, and the second light source unit forms a striped beam pattern in which a plurality of the bright parts extending in a second direction intersecting the first direction are arranged along the flow direction.

According to the configuration of [17] above, it becomes possible to perform more advanced shape estimation of the particle from the measurement result (time waveform) for each wavelength.

[18] The laser measurement device according to any one of [1] to [17], wherein the light source temporally modulates an intensity of the laser light.

According to the configuration of [18] above, it becomes possible to easily grasp background noise generated during measurement from the measurement result (time waveform).

[19] A laser measurement method using the laser measurement device according to any one of [1] to [18], including: a step of forming a beam pattern in which at least two bright parts are arranged with a dark part interposed therebetween along a flow direction of a fluid in a sample flow path through which the fluid containing a particle to be measured passes in the flow path device, by emitting the laser light from the light source to the flow path device; a step of detecting emitted light emitted from the particle when the particle passes through a region where the beam pattern is formed; and a step of determining at least one of a shape and a size of the particle based on the detected emitted light.

According to the above laser measurement method, the same effects as those of the laser measurement device of [1] above can be obtained. That is, since a beam pattern suitable for particle measurement using a flow path device can be formed with high precision and ease, at least one of the shape and the size of the particle can be determined with high accuracy based on the detection result of the emitted light obtained by the beam pattern.

## Advantageous Effects of Invention

According to an aspect of the present disclosure, it is possible to provide a laser measurement device and a laser measurement method capable of forming a beam pattern suitable for particle measurement using a flow path device with high precision and ease.

## Brief Description of Drawings

FIG. 1 is a diagram schematically showing a configuration of a laser measurement device according to an embodiment.
FIG. 2 is an enlarged view of a portion A in FIG. 1.
FIG. 3 is an enlarged view of the portion A in FIG. 1 viewed from a direction facing a surface-emitting laser.
FIG. 4 is a cross-sectional view of a flow cell taken along line IV-IV in FIG. 2.
FIG. 5 is a partially cutaway perspective view showing an example of the surface-emitting laser.
FIG. 6 is a cross-sectional view showing an example of a laminated structure of the surface-emitting laser.
FIG. 7 is a plan view showing an example of a phase modulation layer.
FIG. 8 is an enlarged view showing a unit configuration region.
FIG. 9 is a plan view showing a first example of a phase distribution of the phase modulation layer.
FIG. 10 is a diagram showing a state in which two beams are emitted from two regions shown in FIG. 9.
FIG. 11 is a perspective view showing a second example of the phase distribution of the phase modulation layer.
FIG. 12 is a diagram showing a first measurement example.
In FIG. 13, (A) is a graph showing light intensity of the surface-emitting laser, (B) is a graph showing a measurement result of emitted light from a sample Sa in FIG. 12, (C) is a graph showing a measurement result of emitted light from a sample Sb in FIG. 12, and (D) is a graph showing a measurement result of emitted light from a sample Sc in FIG. 12.
FIG. 14 is a diagram showing a second measurement example.
In FIG. 15, (A) is a graph showing a measurement result of emitted light from a sample Sd in FIG. 14, (B) is a graph showing a measurement result of emitted light from a sample Se in FIG. 14, (C) is a graph showing a measurement result of emitted light from a sample Sf in FIG. 14, (D) is a graph showing a measurement result of emitted light from a sample Sg in FIG. 14, (E) is a graph showing a measurement result of emitted light from a sample Sh in FIG. 14, and (F) is a graph showing a measurement result of emitted light from a sample Si in FIG. 14.
FIG. 16 is a diagram showing a third measurement example.
FIG. 17 is a diagram showing an example of a beam pattern formed by a combination of a plurality of surface-emitting lasers in the third measurement example.
FIG. 18 is a diagram showing a fourth measurement example.
In FIG. 19, (A) is a graph showing a measurement result of emitted light from a sample Sj in FIG. 18, and (B) is a graph showing a measurement result of emitted light from a sample Sk in FIG. 18.
FIG. 20 is a diagram showing a fifth measurement example.
FIG. 21 is a graph showing a measurement result of emitted light from a sample S in FIG. 20.
FIG. 22 is a diagram showing a sixth measurement example.
FIG. 23 is a diagram showing a seventh measurement example.
FIG. 24 is a diagram showing an eighth measurement example.
In FIG. 25, (A) is a graph showing a measurement result of emitted light from a sample Sl in FIG. 24, and (B) is a graph showing a measurement result of emitted light from a sample Sm in FIG. 24.
In FIG. 26, (A) is a graph showing a measurement result using laser light that is continuous light, and (B) is a graph showing a measurement result according to a ninth measurement example.

FIG. 27 is a graph showing another example of the measurement result of the ninth measurement example.

FIG. 28 is an enlarged view showing a range Rb in FIG. 27.

FIG. 29 is a diagram showing a modification of the arrangement of the plurality of surface-emitting lasers.

FIG. 30 is a diagram schematically showing a configuration of a first modification of the laser measurement device.

FIG. 31 is a diagram schematically showing a configuration of a second modification of the laser measurement device.

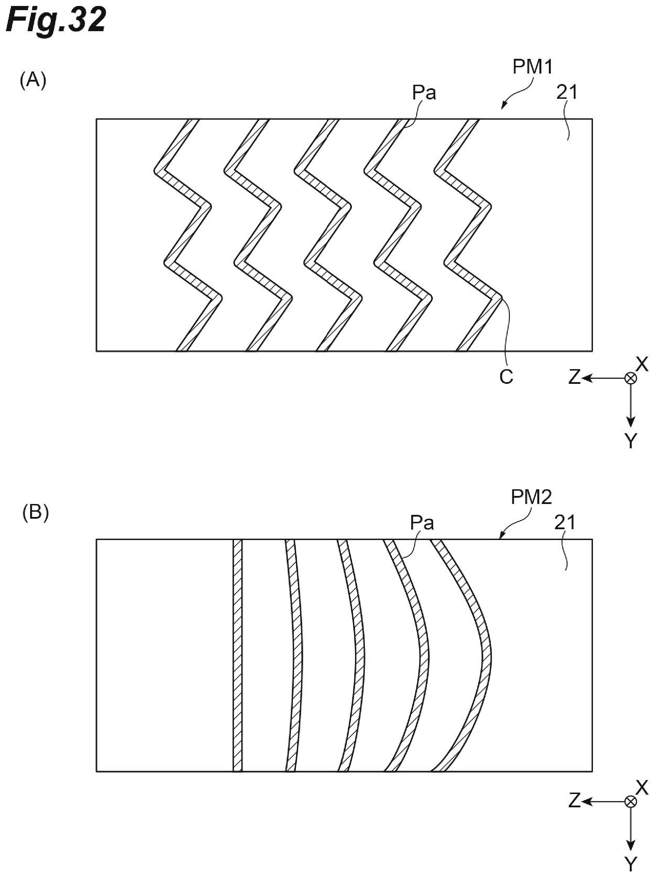

(A) and (B) of FIG. 32 are diagrams showing other examples of the beam pattern.

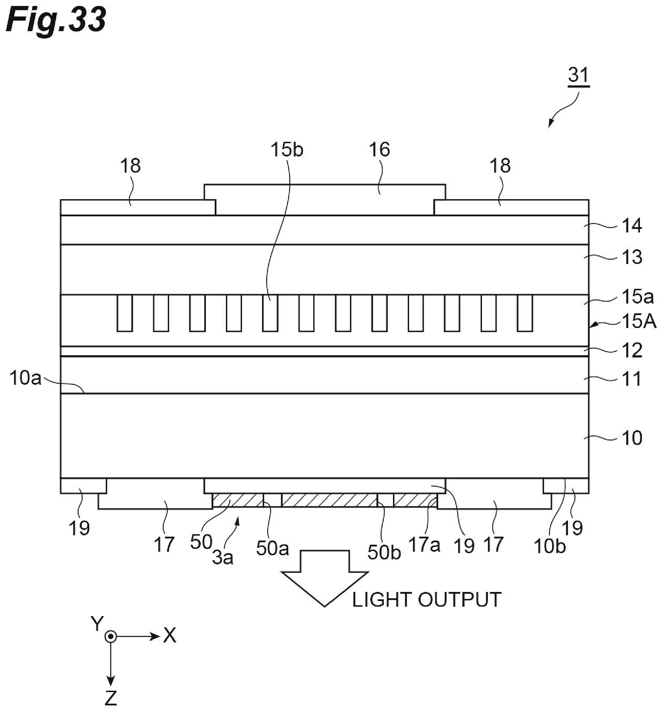

FIG. 33 is a diagram showing a first modification of the light source.

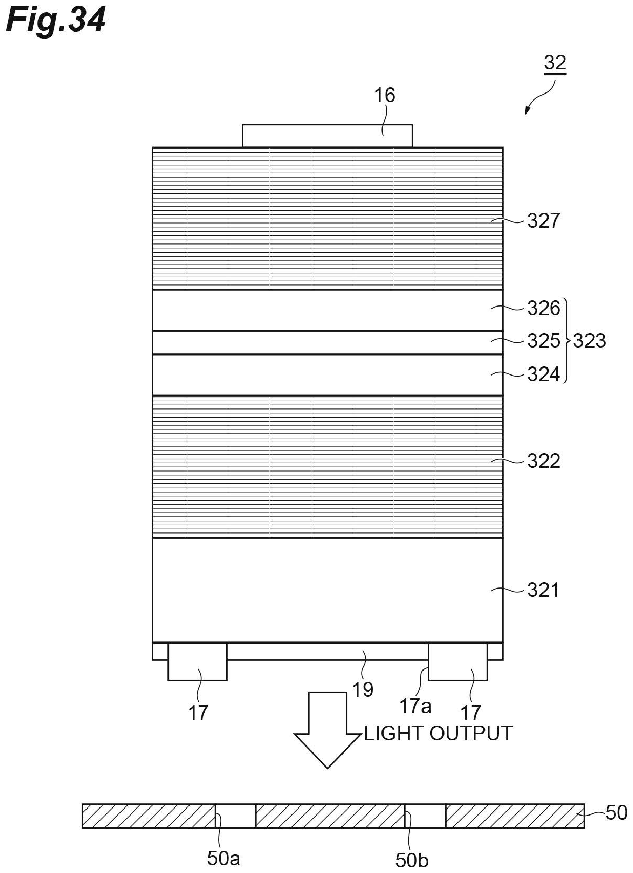

FIG. 34 is a diagram showing a second modification of the light source.

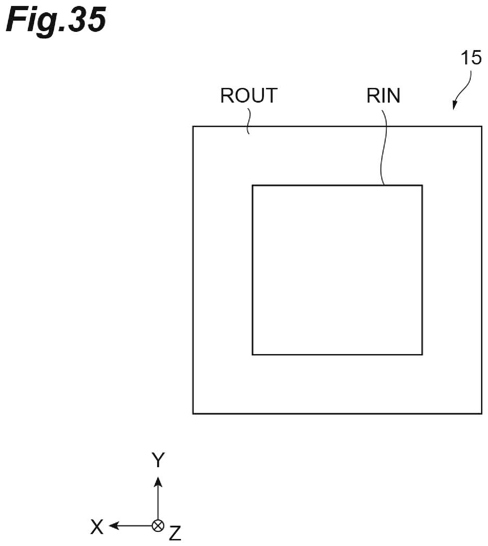

FIG. 35 is a plan view showing an example in which a refractive index substantially periodic structure is applied within a specific region of the phase modulation layer.

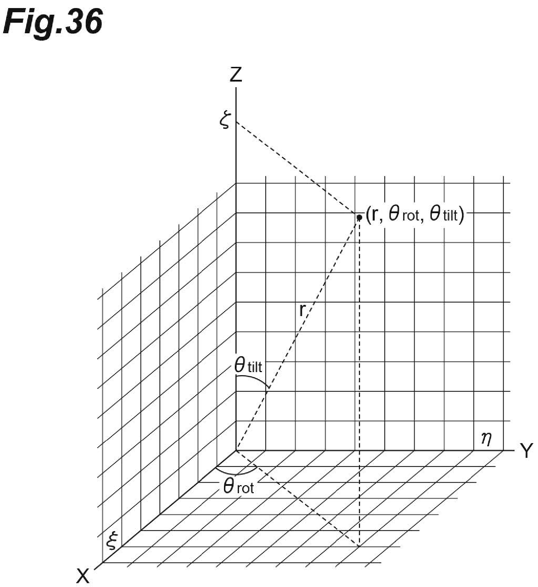

FIG. 36 is a diagram for explaining coordinate conversion from spherical coordinates $(r, \theta rot, \theta tilt)$ to coordinates $(\xi, \eta, \zeta)$ in an XYZ orthogonal coordinate system.

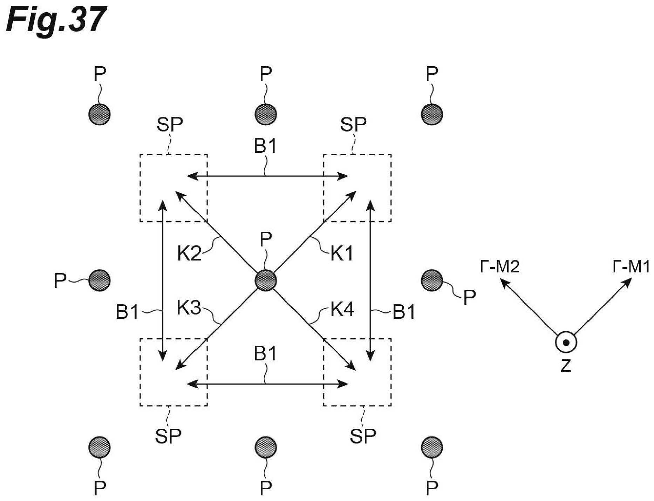

FIG. 37 is a plan view showing a reciprocal lattice space regarding a phase modulation layer of a light emitting device that performs M-point oscillation.

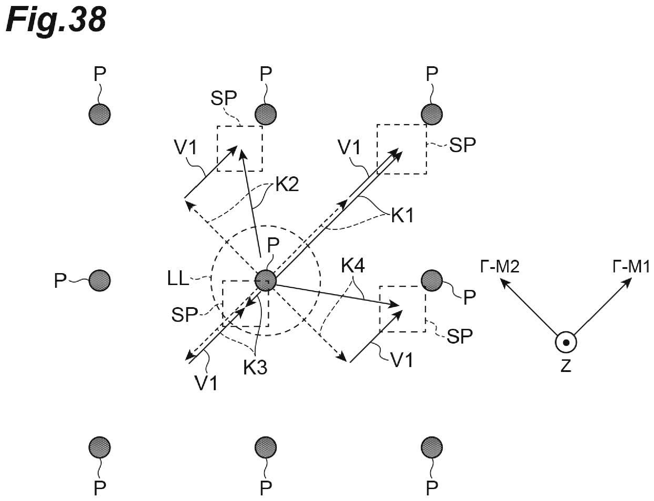

FIG. 38 is a diagram conceptually showing an example of a phase distribution.

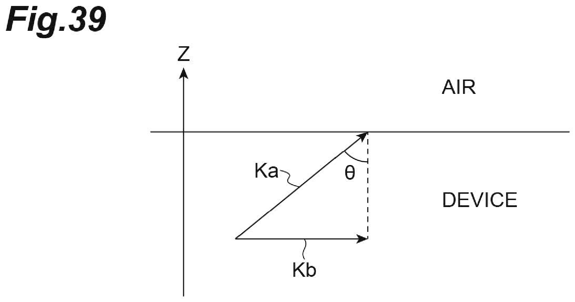

FIG. 39 is a diagram for schematically explaining a peripheral structure of a light line LL.

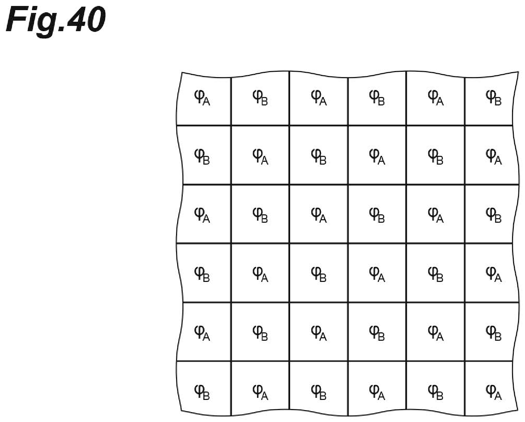

FIG. 40 is a diagram conceptually showing an example of a phase distribution $\phi_2(x, y)$.

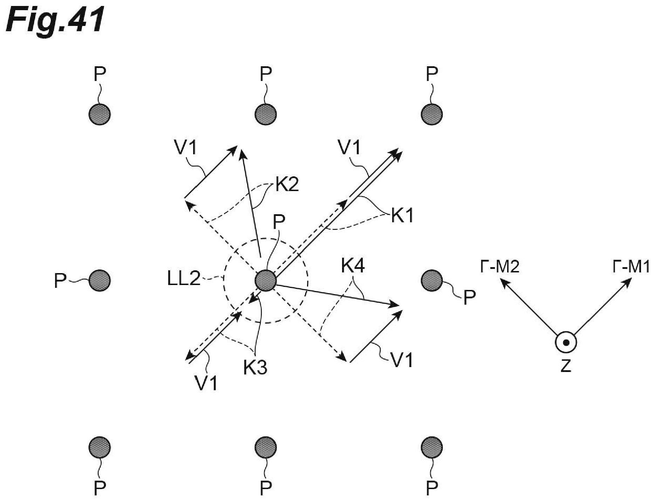

FIG. 41 is a conceptual diagram for explaining a state in which a diffraction vector is added to in-plane wave vectors in four directions from which wavenumber spread is removed.

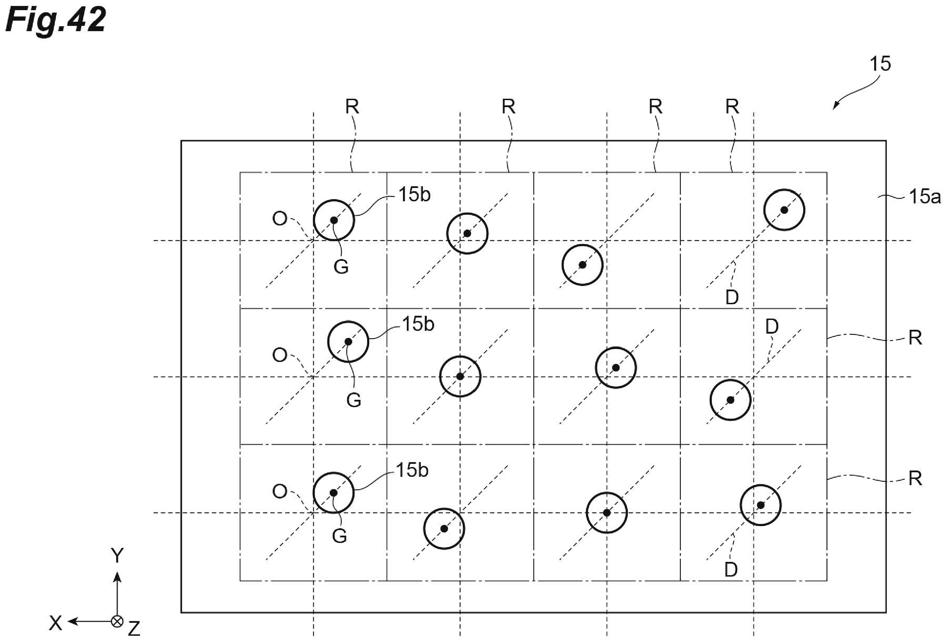

FIG. 42 is a plan view showing another form of the phase modulation layer (first region and second region).

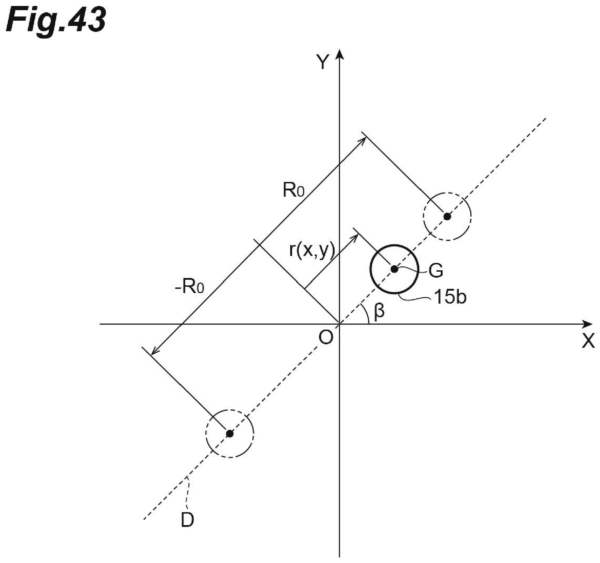

FIG. 43 is a diagram showing an arrangement of different refractive index regions in the phase modulation layer (first region and second region) shown in FIG. 42.

**Description of Embodiments**

Hereinafter, an embodiment of the present disclosure will be described in detail with reference to the drawings. In the following description, identical or corresponding elements are denoted by the same reference signs, and redundant description is omitted.

[Overall Configuration of Laser Measurement Device]

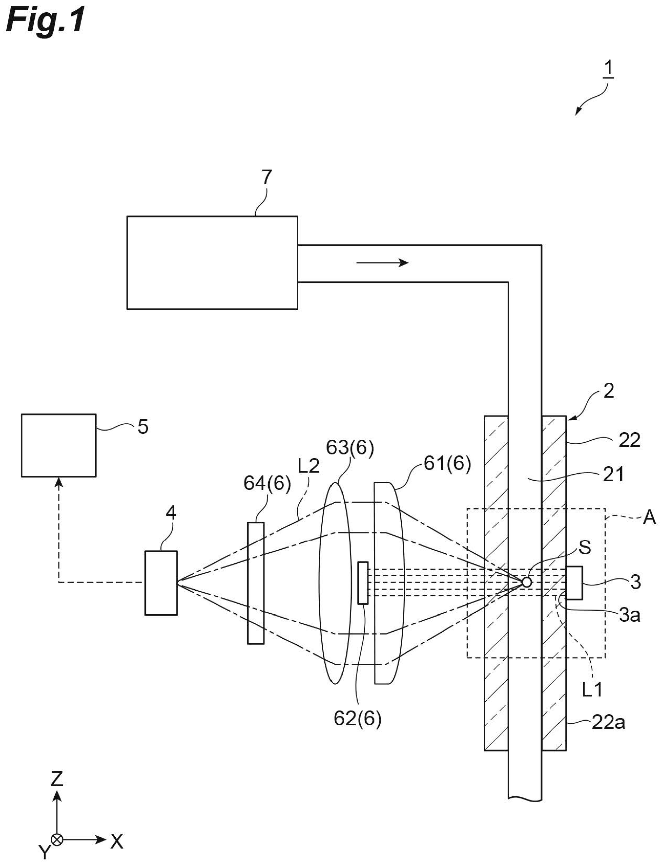

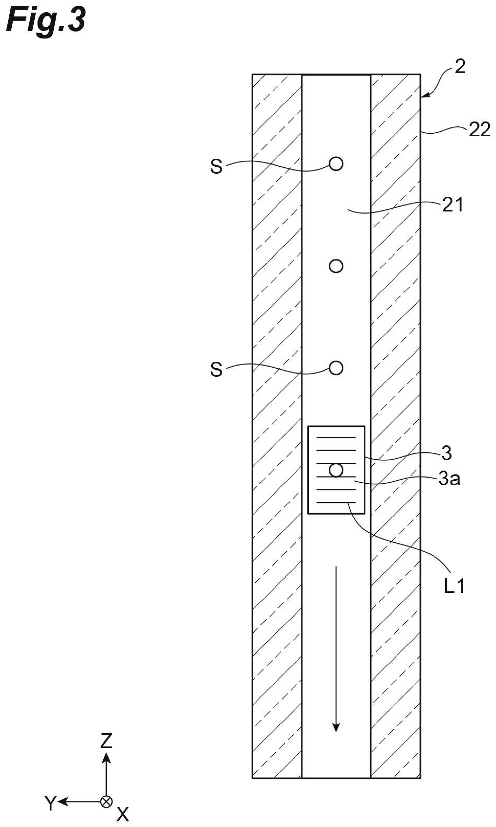

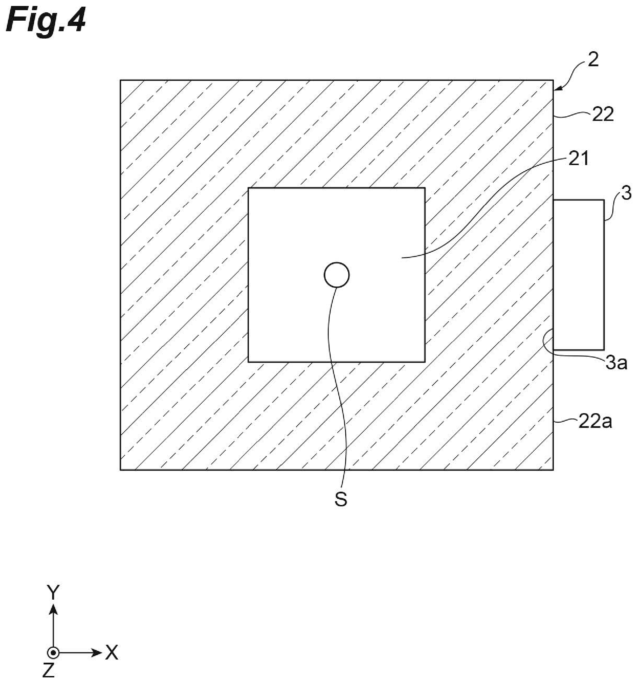

A laser measurement device 1 according to an embodiment of the present disclosure will be described with reference to FIGS. 1 to 4. The laser measurement device 1 is a device for performing particle measurement (for example, measurement of the shape, size, etc. of particles) by flow cytometry. As shown in FIG. 1, the laser measurement device 1 includes a flow cell 2 (flow path device), a surface-emitting laser 3 (light source), a photodetector 4 (sensor), a control unit 5, an optical system 6, and a pump 7.

FIG. 1 shows a configuration in which the laser measurement device 1 includes one surface-emitting laser 3 as a light source, but when forming beam patterns of third to eighth measurement examples described later, the laser measurement device 1 may include a plurality of surface-emitting lasers 3A to 3D (light source units) (in the fourth to eighth measurement examples, two surface-emitting lasers 3A and 3B). Further, FIG. 1 shows a configuration in which the laser measurement device 1 includes one photodetector 4 as a sensor, but when forming beam patterns of fifth to eighth measurement examples described later, the laser measurement device 1 may include a plurality (two) of photodetectors 4A and 4B corresponding to each of the plurality (two) of surface-emitting lasers 3A and 3B. Configurations of the light source and the sensor corresponding to each measurement example will be described in the description of each measurement example.

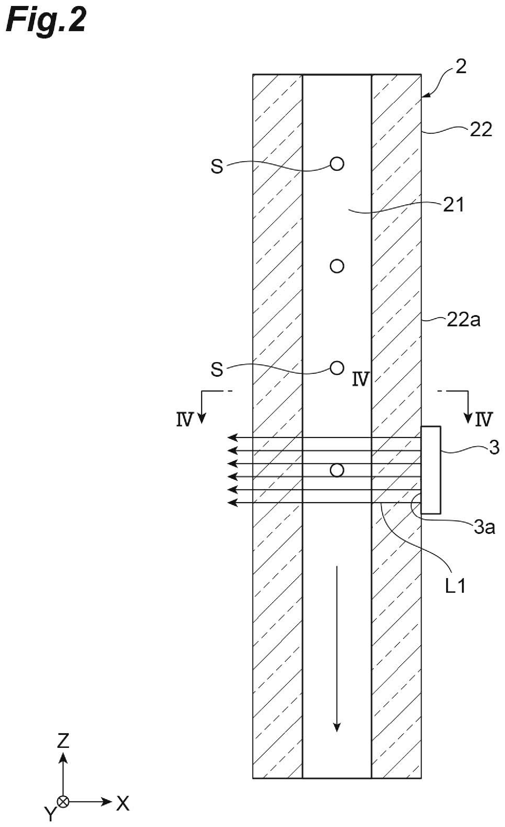

The flow cell 2 includes a sample flow path 21 through which a fluid containing a sample S (see FIGS. 2 to 4), which is a particle to be measured, passes. The sample S is, for example, a minute particle such as a cell, an extracellular vesicle, or a biological substance. The fluid containing the sample S is fed into the sample flow path 21 by the pump 7. In the present embodiment, the flow cell 2 has a tubular side wall 22 that surrounds the sample flow path 21 and extends in one direction (Z-axis direction). As an example, the side wall 22 is formed in a rectangular annular shape when viewed from the flow direction (Z-axis direction) of the fluid in the flow cell 2. The side wall 22 is formed of a member having transparency to laser light L1 emitted from the surface-emitting laser 3 and emitted light L2 emitted from the sample S. That is, the side wall 22 transmits the laser light L1 and the emitted light L2. Examples of the member having transparency include glass, quartz, synthetic resin, and the like.

In the sample flow path 21, a flow of a sample suspension containing the sample S (sample flow) and a flow of a sheath liquid formed around the sample flow (sheath flow) are formed. In the present embodiment, the sample flow and the sheath flow in the sample flow path 21 are illustrated without distinction. The fluid forming the sample flow and the sheath flow is, for example, water. When the width of the sample flow is set to be small to some extent by controlling the pressure of the sample flow and the pressure of the sheath flow, each sample S flows sequentially through a substantially central portion in the sample flow path 21. On the other hand, when the width of the sample flow is set to be large to some extent, the sample S also flows at a position other than the substantially central portion in the sample flow path 21 (that is, a position shifted from the central portion of the sample flow path 21 toward the side wall 22).

For convenience, in the specification and the drawings, a direction along the flow direction of the fluid in the flow cell 2 is referred to as a Z-axis direction, a direction orthogonal to a side surface 22a of the side wall 22 to which the surface-emitting laser 3 is attached (in other words, a direction orthogonal to a light emission surface 3a of the surface-emitting laser 3) is referred to as an X-axis direction, and a direction orthogonal to both the Z-axis direction and the X-axis direction is referred to as a Y-axis direction.

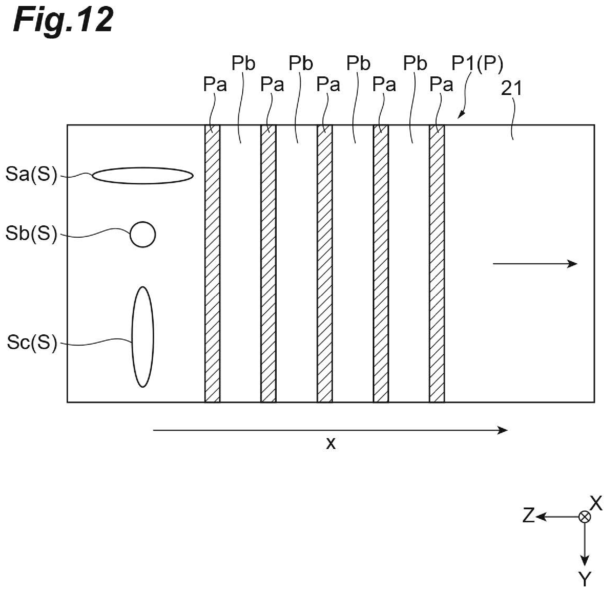

The surface-emitting laser 3 is a surface-emitting laser that emits the laser light L1 such that a beam pattern P in which at least two bright parts Pa are arranged with a dark part Pb interposed therebetween along the flow direction (Z-axis direction) of the fluid in the flow cell 2 is formed in the sample flow path 21 (see FIG. 12). In other words, the beam pattern P includes a portion where the bright part Pa and the dark part Pb appear alternately along the Z-axis direction. FIGS. 1 to 3 schematically show the laser light L1 forming a beam pattern P1 (FIG. 12) of a first measurement example described later. As an example, the surface-emitting laser 3 is fixed to the side wall 22 of the flow cell 2. More specifically, the surface-emitting laser 3 is fixed to the flow cell 2 such that the light emission surface 3a of the surface-emitting laser 3 faces one side surface 22a of the side wall 22 (an outer surface opposite to an inner surface on the sample flow path 21 side). The surface-emitting laser 3 is attached to the side surface 22a by, for example, direct bonding by semiconductor process technology, bonding with an adhesive, screwing, or the like. A configuration example of the surface-emitting laser 3 will be described later. However, the surface-emitting laser 3 does not have to be fixed to the flow cell 2 (side wall 22), and may be arranged at a position away from the flow cell 2. For example, the surface-emitting laser 3 may be arranged at a position away from the flow cell 2 in a range of, for example, 20 mm or less in order to adjust the size of the beam pattern P (for example, the pitch between adjacent bright parts Pa of the striped beam pattern P1, etc.).

The photodetector 4 is a sensor that detects the emitted light L2 emitted from the sample S when the sample S passes through the region where the beam pattern P is formed in the sample flow path 21. Examples of the emitted light L2 include scattered light, fluorescence, and the like. In the present embodiment, the photodetector 4 detects scattered light as the emitted light L2. The scattered light includes forward scattered light traveling in the same direction as the irradiation direction of the laser light L1 with respect to the sample S, and side scattered light traveling in a direction orthogonal to the irradiation direction, but in the present embodiment, the photodetector 4 is configured to detect the forward scattered light as the emitted light L2. That is, the photodetector 4 is arranged at a position facing the surface-emitting laser 3 with the sample flow path 21 interposed therebetween in order to detect the forward scattered light from the sample S.

The control unit 5 acquires a measurement result (time waveform) of signal intensity detected by the photodetector 4, and executes various analysis processes (for example, determination (estimation) of the shape and size of the sample S in each measurement example described later, etc.) based on the measurement result. The control unit 5 can be configured by, for example, one or more computer devices including a processor, a memory, an auxiliary storage device, and the like.

The optical system 6 is composed of a plurality of optical members arranged to efficiently guide only the emitted light L2 to the photodetector 4. The optical system 6 is arranged between the flow cell 2 and the photodetector 4. The optical system 6 has a collimating lens 61, a light shielding plate 62, a condensing lens 63, and an optical filter 64. The collimating lens 61, the light shielding plate 62, the condensing lens 63, and the optical filter 64 are arranged in this order from the flow cell 2 side toward the photodetector 4 side.

The collimating lens 61 is a lens for collimating the emitted light L2 emitted from the sample S. The light shielding plate 62 is a member for shielding the laser light L1 in order to prevent the laser light L1 from entering the photodetector 4. The condensing lens 63 is a lens for condensing the emitted light L2 collimated by the collimating lens 61 onto a light receiving surface of the photodetector 4. The optical filter 64 is a filter member configured to transmit only the emitted light L2. For example, the optical filter 64 is a bandpass filter configured to transmit only a wavelength band corresponding to the emitted light L2.

[Configuration Example of Surface-Emitting Laser]

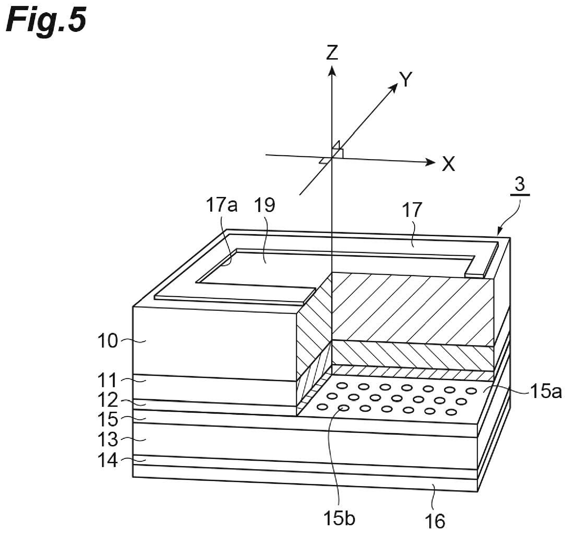

A configuration example of the surface-emitting laser 3 will be described with reference to FIGS. 5 to 11. In FIGS. 5 to 11, an XYZ orthogonal coordinate system is defined in which an axis extending in the thickness direction of the surface-emitting laser 3 at the center of the surface-emitting laser 3 is the Z axis. Note that the XYZ orthogonal coordinate system in FIGS. 5 to 11 is irrelevant to the XYZ orthogonal coordinate system in other drawings (that is, the XYZ orthogonal coordinate system defined with the flow direction of the fluid in the flow cell 2 defined above as the Z-axis direction).

The surface-emitting laser 3 is a laser light source that forms a standing wave in an in-plane direction of the XY plane and outputs a phase-controlled plane wave in a direction intersecting its thickness direction. The surface-emitting laser 3 is an S-iPM laser, and can output an optical image of an arbitrary shape in a direction perpendicular to a main surface 10a of a semiconductor substrate 10 (Z-axis direction) or a direction inclined with respect thereto, or a direction including both. The surface-emitting laser 3 may be an S-iPMSEL (registered trademark) manufactured by Hamamatsu Photonics K.K.

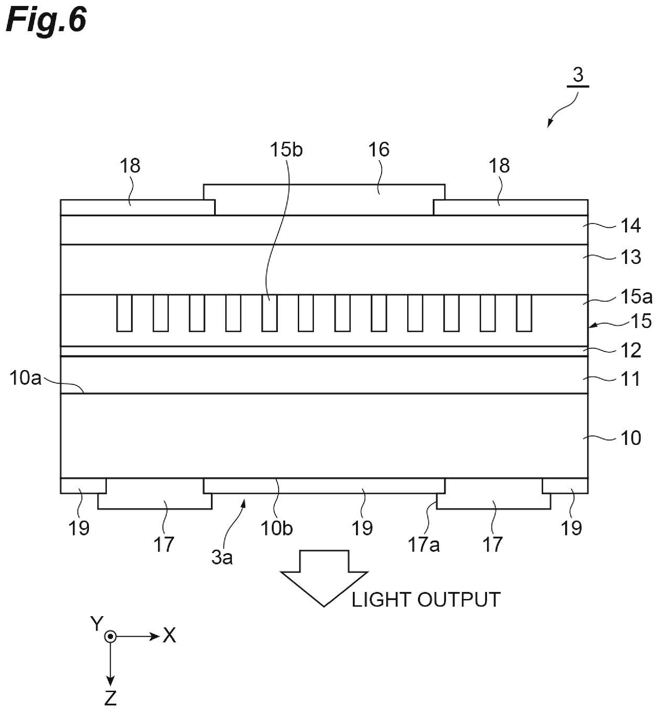

As shown in FIGS. 5 and 6, the surface-emitting laser 3 includes an active layer 12 as a light emitting unit provided on the semiconductor substrate 10, a pair of cladding layers 11 and 13 sandwiching the active layer 12, and a contact layer 14 provided on the cladding layer 13. The semiconductor substrate 10, the cladding layers 11 and 13, and the contact layer 14 are made of a compound semiconductor such as a GaAs-based semiconductor, an InP-based semiconductor, or a nitride-based semiconductor. An energy band gap of the cladding layer 11 and an energy band gap of the cladding layer 13 are larger than an energy band gap of the active layer 12. The thickness direction of the semiconductor substrate 10, the cladding layer 11, the active layer 12, the cladding layer 13, and the contact layer 14 coincides with the Z-axis direction.

The surface-emitting laser 3 further includes a phase modulation layer 15 optically coupled to the active layer 12. In the present embodiment, the phase modulation layer 15 is provided between the active layer 12 and the cladding layer 13. The thickness direction of the phase modulation layer 15 coincides with the Z-axis direction. The phase modulation layer 15 may be provided between the cladding layer 11 and the active layer 12. An optical guide layer may be provided between the active layer 12 and the cladding layer 13 and between the active layer 12 and the cladding layer 11, as necessary, on at least one side. The optical guide layer may include a carrier barrier layer for efficiently confining carriers in the active layer 12.

The phase modulation layer 15 is configured to include a base layer 15a made of a first refractive index medium, and a plurality of different refractive index regions 15b made of a second refractive index medium having a refractive index different from that of the first refractive index medium and existing in the base layer 15a. The plurality of different refractive index regions 15b include a lattice-like substantially periodic structure. When an equivalent refractive index of a mode is n and a lattice spacing is a, a wavelength $\lambda_0$ selected by the phase modulation layer 15 is expressed as $\lambda_0 = (\sqrt{2})a \times n$. This wavelength $\lambda_0$ is a wavelength included in the emission wavelength range of the active layer 12. The phase modulation layer 15 can select a band edge wavelength near the wavelength $\lambda_0$ among the emission wavelengths of the active layer 12 and output it to the outside. At this time, as the photonic band edge, an M-point band edge of a square lattice having no zero-order light noise in the vertical direction can be used. Alternatively, the photonic band edge may be a J-point band edge of a triangular lattice. Light incident into the phase modulation layer 15 forms a predetermined mode according to the arrangement of the different refractive index regions 15b in the phase modulation layer 15, and is emitted to the outside from the surface of the surface-emitting laser 3 as laser light.

The surface-emitting laser 3 further includes an electrode 16 provided on the contact layer 14 and an electrode 17 provided on a back surface 10b of the semiconductor substrate 10. The electrode 16 makes ohmic contact with the contact layer 14. The electrode 17 makes ohmic contact with the semiconductor substrate 10. The electrode 17 has an opening 17a in a central region of the back surface 10b. The electrode 16 is provided in a central region of the surface of the contact layer 14. A portion other than the electrode 16 on the contact layer 14 is covered with a protective film 18 (see FIG. 6). The contact layer 14 not in contact with the electrode 16 may be removed for limiting a current range. A region other than the region where the electrode 17 is provided on the back surface 10b of the semiconductor substrate 10, including the inside of the opening 17a, is covered with an antireflection film 19. The antireflection film 19 in a region other than the opening 17a may be removed.

In the surface-emitting laser 3, when a drive current is supplied between the electrode 16 and the electrode 17, recombination of electrons and holes occurs in the active layer 12, and the active layer 12 emits light. Electrons and holes contributing to this light emission and light generated in the active layer 12 are efficiently confined between the cladding layer 11 and the cladding layer 13. The light emitted from the active layer 12 enters the inside of the phase modulation layer 15 and forms a predetermined mode according to the lattice structure inside the phase modulation layer 15. The laser light emitted from the phase modulation layer 15 is directly output to the outside of the surface-emitting laser 3 from the back surface 10b through the opening 17a. Alternatively, the laser light emitted from the phase modulation layer 15 is reflected by the electrode 16 and then output to the outside of the surface-emitting laser 3 from the back surface 10b through the opening 17a. That is, in this example, the back surface 10b of the surface-emitting laser 3 functions as the light emission surface 3a. At this time, signal light included in the laser light is emitted in an arbitrary direction including a direction perpendicular to the main surface 10a and a direction inclined with respect to that direction. It is this signal light that constitutes the emitted light from the surface-emitting laser 3. The signal light is mainly +1st-order diffracted light or -1 st-order diffracted light of the laser light (hereinafter referred to as +1st-order light and -1st-order light, respectively), or both.

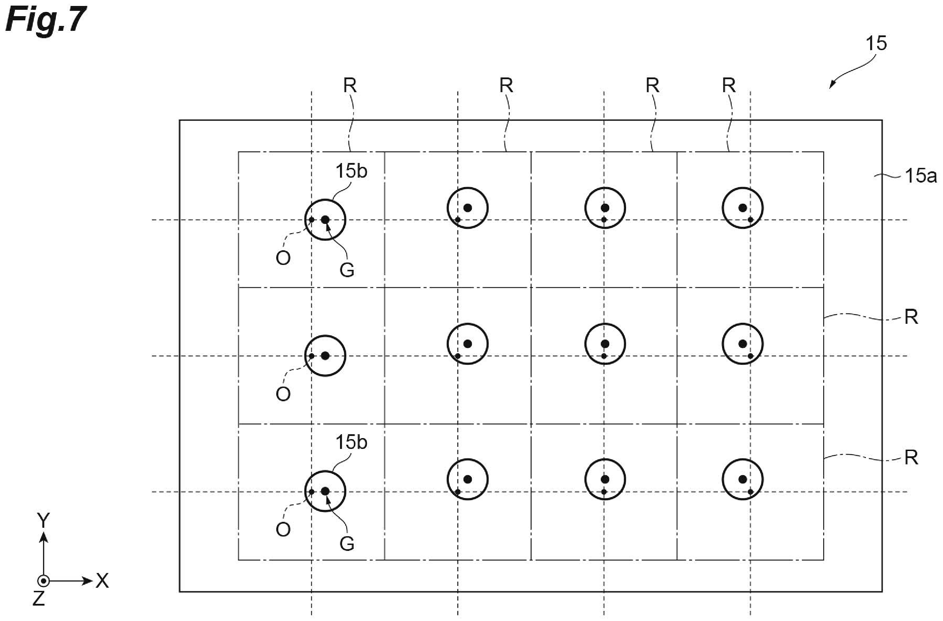

FIG. 7 is a plan view of the phase modulation layer 15. In FIG. 7, a virtual square lattice in the XY plane is set for the phase modulation layer 15. One side of the square lattice is parallel to the X axis, and the other side is parallel to the Y axis. A square unit configuration region R centered on a lattice point O of the square lattice is arranged two-dimensionally over a plurality of columns along the X axis and a plurality of rows along the Y axis. The XY coordinates of each unit configuration region R are defined by the position of the center of gravity of each unit configuration region R. These positions of the center of gravity coincide with the lattice points O of the virtual square lattice. For example, only one different refractive index region 15b is provided in each unit configuration region R. The planar shape of the different refractive index region 15b is, for example, circular. The lattice point O may be located outside the different refractive index region 15b or may be included inside the different refractive index region 15b.

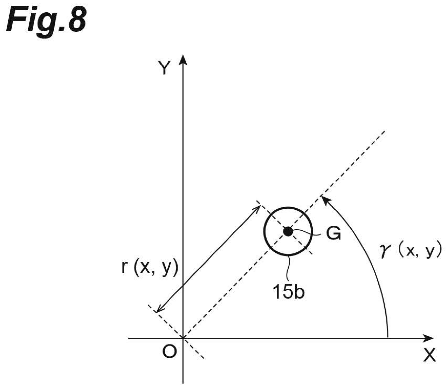

FIG. 8 is an enlarged view showing the unit configuration region R. As shown in the figure, each of the different refractive index regions 15b has a center of gravity G. Here, an angle formed by a vector from the lattice point O to the center of gravity G and the X axis is defined as $\gamma(x, y)$. x indicates the position of the x-th lattice point on the X axis, and y indicates the position of the y-th lattice point on the Y axis. When the rotation angle $\gamma$ is 0°, the direction of the vector connecting the lattice point O and the center of gravity G coincides with the positive direction of the X axis. Further, the length of the vector connecting the lattice point O and the center of gravity G is defined as $r(x, y)$. As an example, $r(x, y)$ is constant throughout the phase modulation layer 15 regardless of x and y. The size of the planar shape of each different refractive index region 15b does not have to be constant and may be set individually.

In the present embodiment, the surface-emitting laser 3 is configured as an iPMSEL. That is, the center of gravity G of each of the plurality of different refractive index regions 15b is arranged at a relative position according to a phase distribution corresponding to the beam pattern (beam pattern P of various measurement examples described later) with respect to each of the plurality of lattice points O arranged periodically. In other words, the center of gravity G of each different refractive index region 15b is arranged at a relative position corresponding to a phase modulation amount of a predetermined phase distribution with respect to the corresponding lattice point O. That is, as shown in FIG. 7, the direction of the vector connecting the lattice point O and the center of gravity G, in other words, the rotation angle $\gamma$ of the center of gravity G of the different refractive index region 15b around the lattice point O, is individually set for each lattice point O according to a phase distribution $\phi(x, y)$ corresponding to a desired shape of the emitted light.

As described above, in the present embodiment, the surface-emitting laser 3 is a surface-emitting laser configured to be capable of outputting an optical image of an arbitrary shape according to the setting of the phase distribution $\phi(x, y)$ of the phase modulation layer 15. By using such a surface-emitting laser 3, the beam pattern P of various measurement examples described later can be formed in the sample flow path 21.

For example, in order to suitably form a striped beam pattern P1 according to a first measurement example described later (that is, a pattern in which a plurality of linear bright parts Pa and a plurality of linear dark parts Pb shown in FIG. 12 are alternately arranged), the surface-emitting laser 3 may be configured as follows. That is, the surface-emitting laser 3 may form the striped beam pattern P1 by causing lights emitted from respective ones of a plurality of regions different from each other in the in-plane direction of the light emission surface 3a (that is, the direction along the XY plane in FIGS. 5 to 11) to interfere with each other. According to the above configuration, a fine striped beam pattern P1 (that is, a pattern with a minute pitch between the plurality of bright parts Pa) can be formed with high precision in a space relatively close to the light emission surface 3a of the surface-emitting laser 3. This makes it possible to suitably perform measurement of the size of minute particles such as cells while achieving miniaturization of the laser measurement device 1 (module) by arranging the surface-emitting laser 3 close to the flow cell 2.

Two examples (first example, second example) of phase distribution for forming the striped beam pattern P1 in a space relatively close (for example, about 1 mm) to the light emission surface 3a of the surface-emitting laser 3 will be described below. However, the phase distribution for forming the beam pattern P1 is not limited to the following first and second examples. Further, when forming a beam pattern other than a striped shape, the phase distribution of the phase modulation layer 15 is set according to the shape of the beam pattern.

(First Example of Phase Distribution)

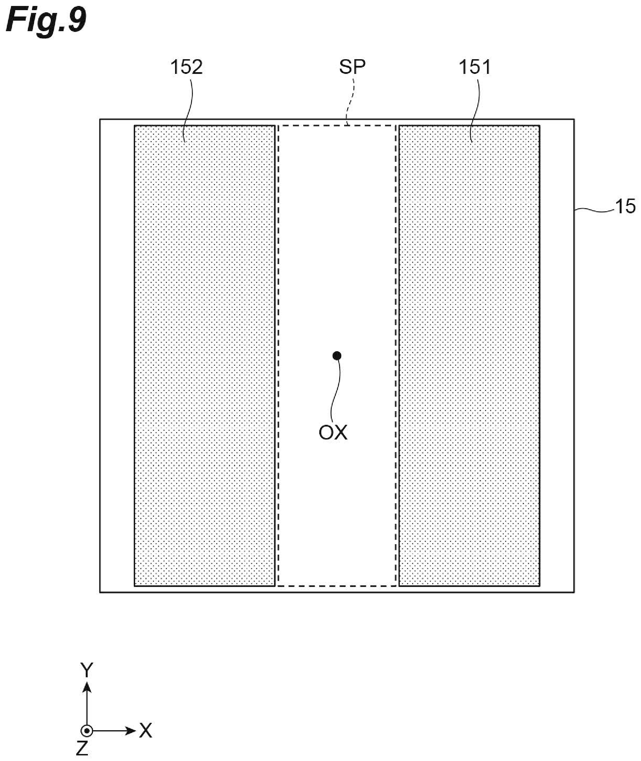

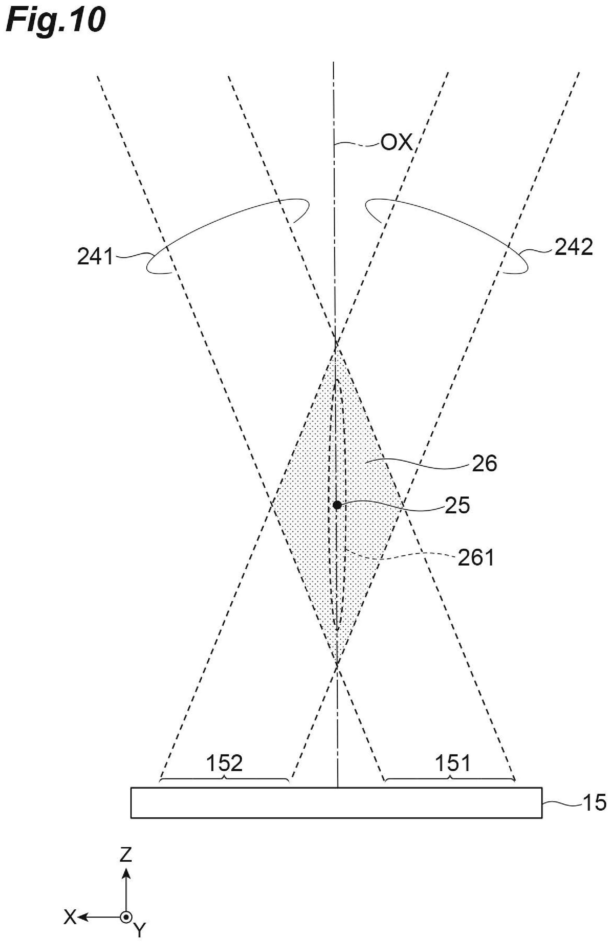

A first example of the phase distribution of the phase modulation layer 15 will be described with reference to FIGS. 9 and 10. In the first example, the phase distribution of the phase modulation layer 15 has regions including a one-dimensional lens pattern in which the phase changes in one direction (for example, the X-axis direction) (corresponding to a first region 151 and a second region 152 described later) on both sides of the optical axis in the one direction. By the one-dimensional lens pattern, a first beam emitted from a region on one side of the optical axis (corresponding to the first region 151 described later) and a second beam emitted from a region on the other side of the optical axis (corresponding to the second region 152 described later) intersect each other at a certain position (first position) and then separate.

FIG. 9 is a plan view showing an example of the phase distribution of the phase modulation layer 15. The phase distribution of the phase modulation layer 15 may have the first region 151 on one side of an optical axis OX in one direction (X-axis direction in the illustrated example) and the second region 152 on the other side of the optical axis OX in the same direction. In this case, the optical axis OX is located between the first region 151 and the second region 152. The distance from the first region 151 to the optical axis OX is equal to the distance from the second region 152 to the optical axis OX. In other words, the planar shape of the first region 151 and the planar shape of the second region 152 are line-symmetric with respect to a straight line passing through the optical axis OX and extending in the Y-axis direction. The optical axis OX is a central axis of light emitted from the surface-emitting laser 3, and is typically a center line of the surface-emitting laser 3 along the Z-axis direction. The first region 151 and the second region 152 have a planar shape such as a rectangular shape, and extend in a direction intersecting the X-axis direction (Y-axis direction in the illustrated example). The longitudinal direction of the first region 151 is parallel to the longitudinal direction of the second region 152. A gap SP including the optical axis OX is provided between the first region 151 and the second region 152. The width of the gap SP in the X-axis direction is arbitrary.

The first region 151 and the second region 152 include a one-dimensional lens pattern in which the phase changes in the arrangement direction of the first region 151 and the second region 152, that is, the X-axis direction. FIG. 10 is a diagram showing a state in which beams 241 and 242 are emitted from the first region 151 and the second region 152 shown in FIG. 9. A beam 241 (first beam) which is +1st-order light is emitted from the first region 151. A beam 242 (second beam) which is +1st-order light is emitted from the second region 152. The beam 241 and the beam 242 intersect each other at a first position 25 and then separate. The first position 25 is defined as the center position of a region 26 (shown by dots in the figure) where the beam 241 and the beam 242 overlap in the XZ plane. When the width of the first region 151 in the X-axis direction is equal to the width of the second region 152 in the same direction, the region 26 exhibits a rhombus shape when viewed from the Y-axis direction. In the region 26, a condensing spot 261 extending in the light emission direction centered on the first position 25 is formed. The first position 25 may be located on the optical axis OX or may be away from the optical axis OX.

According to the above configuration, by causing interference in the region 26 where the beam 241 and the beam 242 overlap, a striped optical image extending in the Y-axis direction (that is, a beam pattern including a plurality of linear bright parts arranged in the X-axis direction) can be formed.

(Second Example of Phase Distribution)

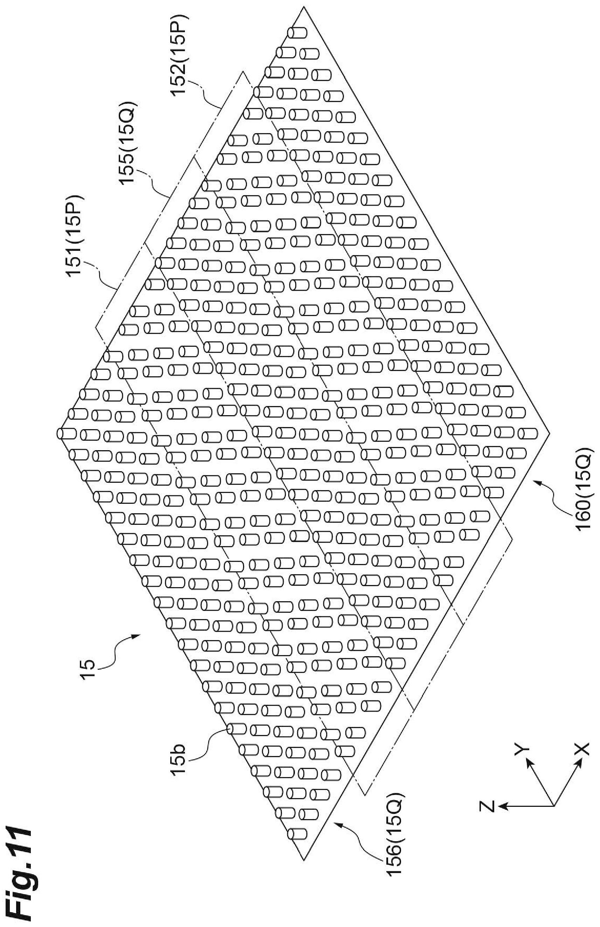

A second example of the phase distribution of the phase modulation layer 15 will be described with reference to FIG. 11. As shown in FIG. 11, in the second example, a light extraction region 15P including a first region 151 and a second region 152 spaced apart from the first region 151 is formed in the phase modulation layer 15 according to the arrangement of the plurality of different refractive index regions 15b. In the light extraction region 15P, the plurality of different refractive index regions 15b are arranged such that light resonating in the in-plane direction of the XY plane is diffracted in the out-of-plane direction in the first region 151 and the second region 152. Further, in an intermediate region 155, the plurality of different refractive index regions 15b are arranged such that light resonating in the in-plane direction is not diffracted in the out-of-plane direction. The first region 151 and the second region 152 are linear regions elongated in the Y-axis direction. Thereby, a pseudo double slit using each of the first region 151 and the second region 152 as a slit is realized, and interference fringes due to interference of emitted light can be formed in the Fresnel region. That is, it becomes possible to form a fine striped pattern (beam pattern P1) at a relatively short distance from the light emission surface 3a.

[Measurement Example]

Hereinafter, various beam patterns P will be described, and measurement examples corresponding to each beam pattern P will be described.

(First Measurement Example)

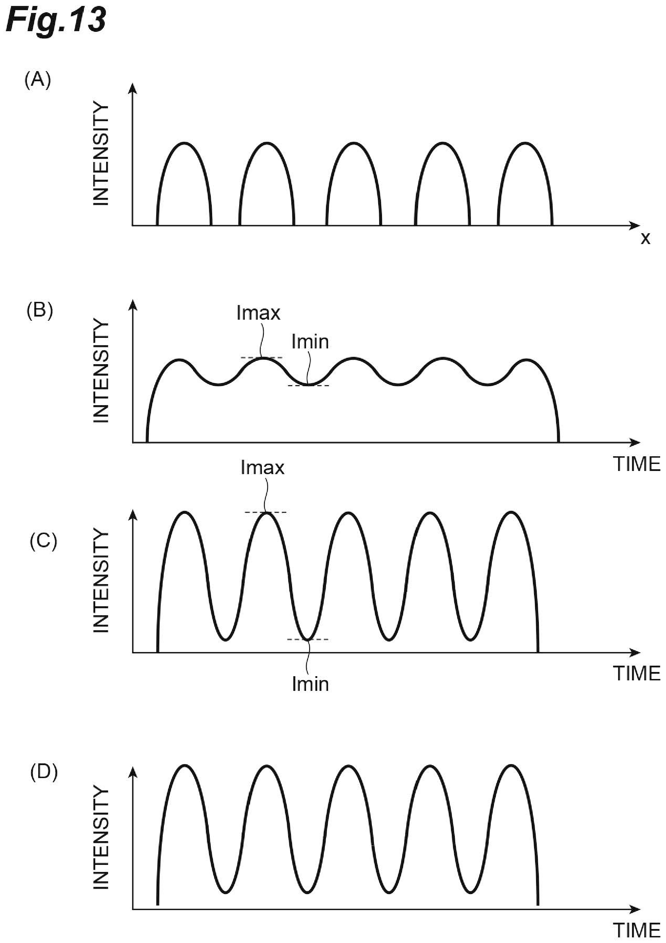

A first measurement example using the striped beam pattern P1 will be described with reference to FIGS. 12 and 13. In the first measurement example, the surface-emitting laser 3 is configured to form a plurality of (five as an example) linear bright parts Pa extending in a direction (Y-axis direction) intersecting the flow direction (Z-axis direction) of the flow cell 2 and the emission direction (X-axis direction) of the laser light L1. As shown in FIG. 12, the beam pattern P1 has a pattern shape in which linear bright regions (bright parts Pa) and linear dark regions (dark parts Pb) are alternately arranged along the Z-axis direction when viewed from the X-axis direction. (A) of FIG. 13 shows a graph in which the horizontal axis is a coordinate corresponding to the x-axis direction of FIG. 12 and the vertical axis is the intensity of the beam pattern P1 formed by the laser light L1. As shown in (A) of FIG. 13, the beam pattern P1 has a peak at a position corresponding to each of the five bright parts Pa.

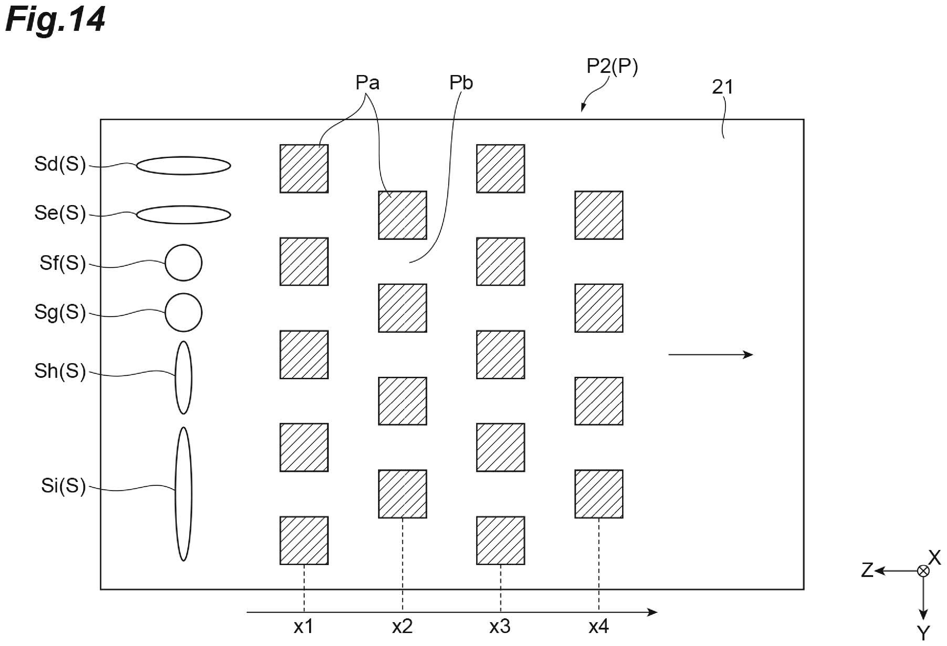

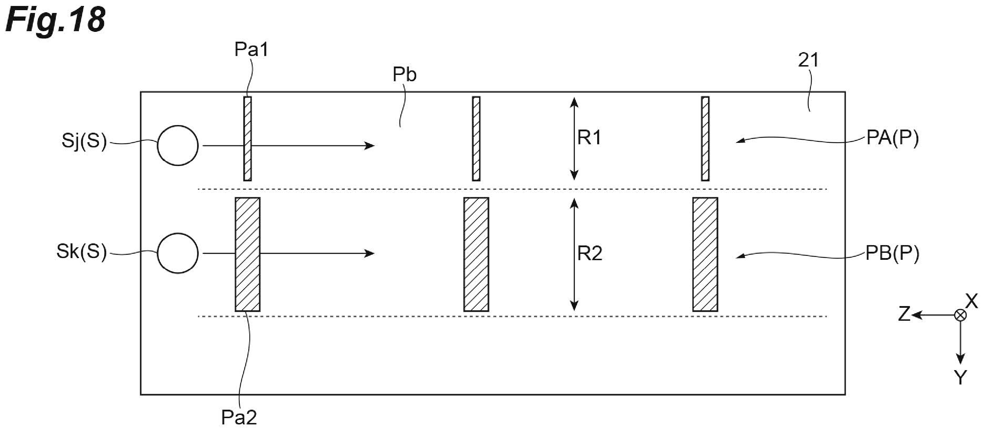

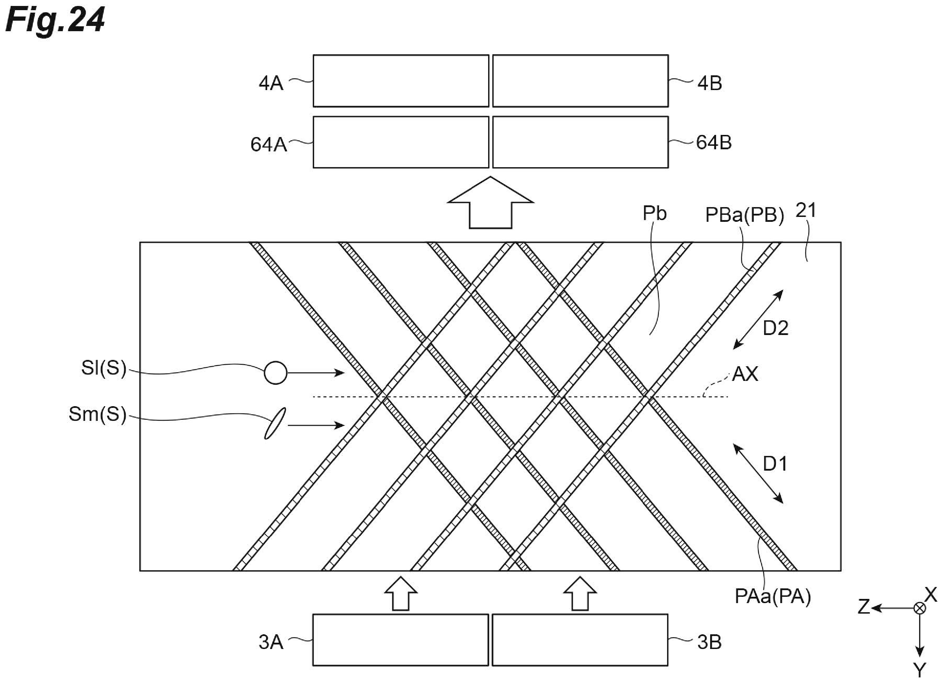

As shown in FIG. 12, here, a sample Sa having a long and thin shape in the Z-axis direction, a spherical sample Sb, and a sample Sc having a long and thin shape in the Y-axis direction are considered. Note that FIG. 12 illustrates a state in which a plurality of samples Sa to Sc exist simultaneously in the sample flow path 21, but each sample Sa to Sc is measured separately. That is, each sample Sa to Sc passes through the region where the beam pattern P1 is formed at timings different from each other. This also applies to the second measurement example of FIG. 14, the fourth measurement example of FIG. 18, and the seventh measurement example of FIG. 24.

(B) of FIG. 13 is a graph (time waveform) showing a measurement result of the emitted light L2 from the sample Sa of FIG. 12, (C) is a graph showing a measurement result of the emitted light L2 from the sample Sb of FIG. 12, and (D) is a graph showing a measurement result of the emitted light L2 from the sample Sc of FIG. 12. In each graph, the horizontal axis indicates time, and the vertical axis indicates the signal intensity of the emitted light L2 (forward scattered light in the present embodiment) detected by the photodetector 4.

In the measurement results (time waveforms) of each sample Sa to Sc shown in (B) to (D) of FIG. 13, peaks corresponding to respective timings when each sample Sa to Sc passes through positions overlapping with the five bright parts Pa are observed. Here, when the light intensity of the peak (peak portion) of the time waveform is expressed as Imax and the light intensity of the bottom (valley portion) is expressed as Imin, the modulation depth M of the measurement result can be obtained by the following formula (0).

$$M = (Imax - Imin) / (Imax + Imin) \ldots (0)$$

According to the first measurement example, the control unit 5 can determine the size (length in the Z-axis direction) of the sample S based on the amplitude modulation of the signal intensity of the emitted light L2 represented in the measurement result (time waveform). More specifically, as shown in (C) and (D) of FIG. 13, in the case of the samples Sb and Sc having a short length in the Z-axis direction, since the samples Sb and Sc do not overlap with a plurality of bright parts Pa at the same time (or the period not overlapping with the bright parts Pa becomes relatively long), the modulation depth M obtained by the above formula (0) becomes relatively large. On the other hand, as shown in (B) of FIG. 13, in the case of the sample Sa having a long length in the Z-axis direction, since there is a period in which the sample Sa overlaps with a plurality of bright parts Pa at the same time (or the period not overlapping with the bright parts Pa becomes relatively short), the modulation depth M obtained by the above formula (0) becomes relatively small. Therefore, according to the first measurement example, the control unit 5 can determine the size (length in the Z-axis direction) of the sample S based on the magnitude of the modulation depth M. For example, the control unit 5 can determine the size of the sample S based on the modulation depth M obtained from the measurement result of each sample S by using information indicating the correspondence relationship between the modulation depth M obtained by the above formula (0), the interval (pitch) between adjacent bright parts Pa, and the size (length in the Z-axis direction) of the sample S (for example, a modulation curve as shown in FIG. 7 of Patent Literature 1).

Note that the range (size range) of the size (length in the Z-axis direction) of the sample S measurable by the striped beam pattern P1 depends on the distance (pitch) between adjacent bright parts Pa in the beam pattern P1. Specifically, the smaller the size of the sample S to be measured, the shorter the pitch needs to be to determine the size of the sample S. Therefore, in the first measurement example, it is necessary to select and use the surface-emitting laser 3 configured such that the beam pattern P1 having a pitch corresponding to the size range of the sample S to be measured is formed. The pitch between adjacent bright parts Pa is set to, for example, 1 $\mu$m or more and 100 $\mu$m or less.

(Second Measurement Example)

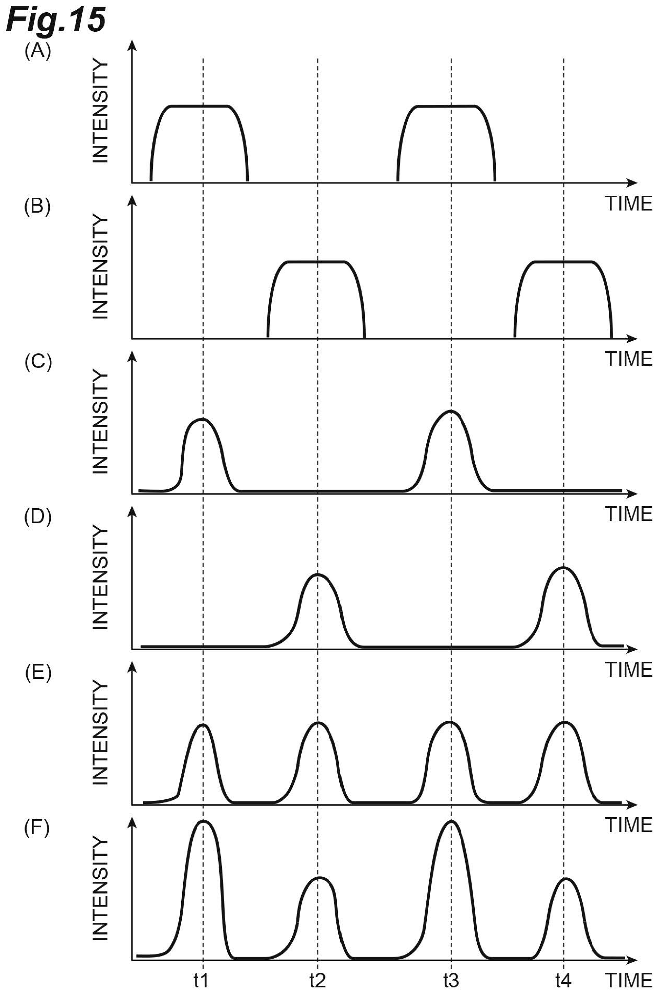

A second measurement example using a dot-shaped beam pattern P2 will be described with reference to FIGS. 14 and 15. As shown in FIG. 14, the beam pattern P2 has a pattern shape in which a plurality of bright parts Pa are scattered in a dot shape when viewed from the X-axis direction. As an example, such a dot-shaped beam pattern P2 can be formed by using the S-iPM laser disclosed in Patent Literature 2 as the surface-emitting laser 3.

In the example of FIG. 14, each bright part Pa is formed in a square shape when viewed from the X-axis direction. Further, the plurality of bright parts Pa are arranged in a rhombic lattice shape when viewed from the X-axis direction. That is, when columns in which the bright parts Pa are arranged in the Z-axis direction are defined as x1 to x4 columns from the upstream side toward the downstream side, the positions in the Y-axis direction of the plurality of bright parts Pa arranged in the odd-numbered columns (x1, x3) are shifted from the positions in the Y-axis direction of the plurality of bright parts Pa arranged in the even-numbered columns (x2, x4). Thereby, the beam pattern P2 has a shape in which the dark part Pb is arranged between two bright parts Pa adjacent in the Z-axis direction (in other words, a shape in which the bright parts Pa and the dark parts Pb are alternately arranged along the Z-axis direction). More specifically, in a flow path flowing through a position overlapping with the bright parts Pa in the odd-numbered columns (in FIG. 14, a flow path through which the samples Sd and Sf pass, a flow path through which the upper half of the sample Sh passes, and a flow path through which the upper part and the lower part of the sample Si pass when the sample Si is trisected), the bright parts Pa are formed in the odd-numbered columns, and the dark parts Pb are formed in regions between adjacent bright parts Pa of the odd-numbered columns. On the other hand, in a flow path flowing through a position overlapping with the bright parts Pa in the even-numbered columns (in FIG. 14, a flow path through which the samples Se and Sg pass, a flow path through which the lower half of the sample Sh passes, and a flow path through which the central part of the sample Si passes when the sample Si is trisected), the bright parts Pa are formed in the even-numbered columns, and the dark parts Pb are formed in regions between adjacent bright parts Pa of the even-numbered columns.

As shown in FIG. 14, here, samples Sd and Se having a long and thin shape in the Z-axis direction, spherical samples Sf and Sg, a sample Sh having a long and thin shape in the Y-axis direction, and a sample Si longer than the sample Sh in the Y-axis direction are considered. Here, it is assumed that the sample flow is set such that each sample Sd to Si flows straight along the Z-axis direction.

(A) of FIG. 15 is a graph showing a measurement result of the emitted light L2 from the sample Sd, (B) is a graph showing a measurement result of the emitted light L2 from the sample Se, (C) is a graph showing a measurement result of the emitted light L2 from the sample Sf, (D) is a graph showing a measurement result of the emitted light L2 from the sample Sg, (E) is a graph showing a measurement result of the emitted light L2 from the sample Sh, and (F) is a graph showing a measurement result of the emitted light L2 from the sample Si. In each graph, the horizontal axis indicates time, and the vertical axis indicates the signal intensity of the emitted light L2 detected by the photodetector 4. Further, time points t1 to t4 on the horizontal axis of each graph indicate time points when each sample Sd to Si passed through positions corresponding to the x1 to x4 columns in FIG. 14.

The samples Sd and Se long in the Z-axis direction have a longer period of overlapping with one bright part Pa than the samples Sf to Si short in the Z-axis direction. Therefore, as shown in (A) and (B) of FIG. 15, in the time waveforms of the samples Sd and Se, peak waveforms longer in the time direction (horizontal axis direction) than the time waveforms of the samples Sf and Sg (see (C) and (D) of FIG. 15) are observed.

The sample Sh long in the Y-axis direction has a size such that it overlaps with one bright part Pa provided in the odd-numbered column and one bright part Pa provided in the even-numbered column. Therefore, as shown in (E) of FIG. 15, peak waveforms are observed not only at time points t1 and t3 passing through the odd-numbered columns (x1, x3) but also at time points t2 and t4 passing through the even-numbered columns (x2, x4).

The sample Si long in the Y-axis direction has a size such that it overlaps with two bright parts Pa provided in the odd-numbered column and one bright part Pa provided in the even-numbered column. Therefore, as shown in (F) of FIG. 15, peak waveforms are observed in both the odd-numbered columns and the even-numbered columns similarly to the sample Sh, and the peaks corresponding to the odd-numbered columns (peaks at time points t1 and t3) are higher than the peaks corresponding to the even-numbered columns (peaks at time points t2 and t4).

As described above, according to the second measurement example, the control unit 5 can determine not only the length of the sample S in the Z-axis direction but also the length in the Y-axis direction based on the measurement result (time waveform) of each sample S. That is, the control unit 5 can determine the length of the sample S along the Z-axis direction based on the width of the peak waveform in the time direction represented in the measurement result (time waveform). Further, the control unit 5 can determine the length of the sample S in the Y-axis direction based on the position where the peak is observed (one of the odd-numbered column and the even-numbered column, or both the odd-numbered column and the even-numbered column) and the peak difference between the odd-numbered column and the even-numbered column.

(Third Measurement Example)

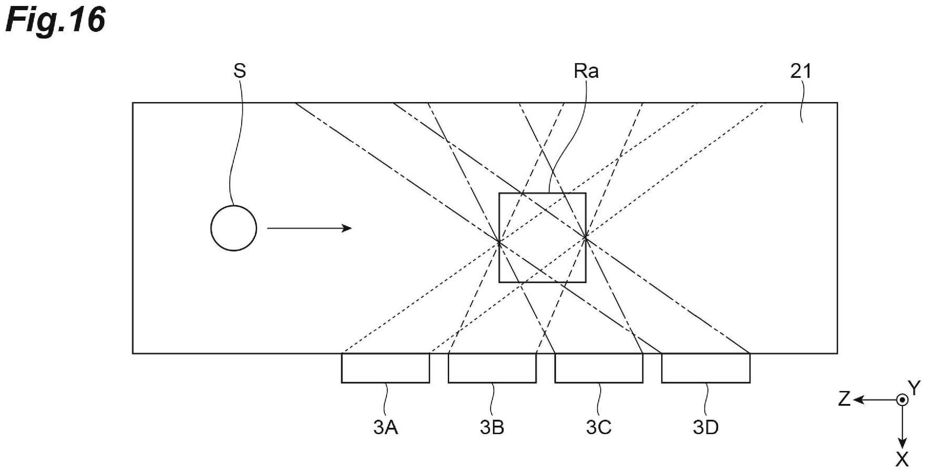

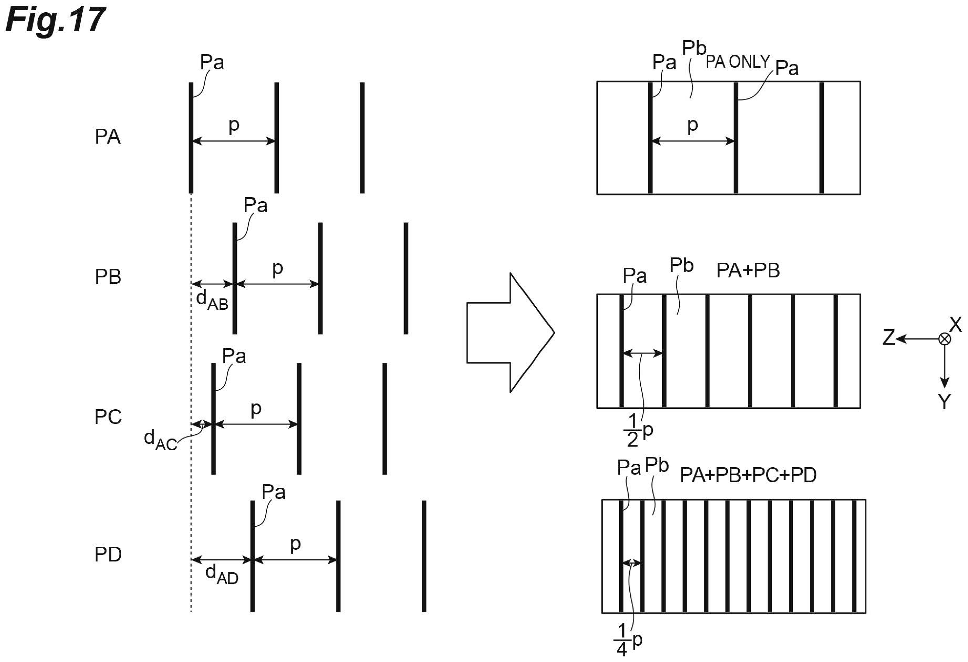

A third measurement example capable of forming various beam patterns by combining a plurality of surface-emitting lasers 3A to 3D will be described with reference to FIGS. 16 and 17. As shown in FIG. 16, in the third measurement example, the laser measurement device 1 includes a plurality of (four as an example) surface-emitting lasers 3A to 3D (plurality of light source units) arranged along the Z-axis direction as light sources. In the third measurement example, all of the surface-emitting lasers 3A to 3D have the same configuration as the surface-emitting laser 3 described above. Note that the surface-emitting lasers 3A and 3B used in the fourth and subsequent measurement examples are irrelevant to the surface-emitting lasers 3A and 3B used in the third measurement example, and are configured to form beam patterns corresponding to each measurement example.

Each of the plurality of surface-emitting lasers 3A to 3D is configured to form striped beam patterns PA to PD (see the left part of FIG. 17) in which a plurality of linear bright parts Pa extending in the Y-axis direction are arranged at predetermined intervals along the Z-axis direction in the sample flow path 21, similarly to the first measurement example. Further, in a passing region Ra through which the sample S passes in the sample flow path 21, the beam patterns PA to PD of each of the plurality of surface-emitting lasers 3A to 3D are arranged so as not to overlap each other. In this example, since the flow of the sample S is controlled so as to pass through the central portion of the sample flow path 21 in the Y-axis direction, the passing region Ra is a region including the central portion of the sample flow path 21 in the Y-axis direction and having a predetermined length in the Z-axis direction.

FIG. 17 is a diagram schematically showing each of the beam patterns PA to PD when viewed from the X-axis direction (when the Z-axis direction corresponds to the horizontal direction in the figure and the Y-axis direction corresponds to the vertical direction in the figure). As shown in the left part of FIG. 17, the bright parts Pa of each of the beam patterns PA to PD are shifted from each other in the Z-axis direction in the passing region Ra, and are arranged so as not to overlap each other. The pitch p (distance between adjacent bright parts Pa) of each of the beam patterns PA to PD is constant. Further, the beam pattern PB is shifted by a distance $d_{AB}$ from the beam pattern PA in the Z-axis direction. Similarly, the beam patterns PC and PD are shifted by distances $d_{AC}$ and $d_{AD}$ from the beam pattern PA in the Z-axis direction. Here, the distance $d_{AB}$ is half the length of the pitch p, the distance $d_{AC}$ is 1/4 the length of the pitch p, and the distance $d_{AD}$ is 3/4 the length of the pitch p.

As shown in the upper right part of FIG. 17, when the laser light L1 is emitted only from the surface-emitting laser 3A, the beam pattern PA in which the distance between adjacent bright parts Pa is "pitch p" can be set. Note that by emitting the laser light L1 from only any one of the surface-emitting lasers 3B, 3C, and 3D, a beam pattern (any of the beam patterns PB to PC) in which the distance between adjacent bright parts Pa is "pitch p" can also be set.

As shown in the middle right part of FIG. 17, when the laser light L1 is emitted from the two surface-emitting lasers 3A and 3B, a beam pattern (beam pattern PA + PB) in which the distance between adjacent bright parts Pa is "half of pitch p" can be set. Note that by emitting the laser light L1 from the surface-emitting lasers 3C and 3D, a beam pattern (beam pattern PC + PD) in which the distance between adjacent bright parts Pa is "half of pitch p" can also be set.

As shown in the lower right part of FIG. 17, when the laser light L1 is emitted from the four surface-emitting lasers 3A to 3D, a beam pattern (beam pattern PA + PB + PC + PD) in which the distance between adjacent bright parts Pa is "1/4 of pitch p" can be set.

As described above, according to the third measurement example, by selecting two or more surface-emitting lasers that emit the laser light L1 from among the plurality of surface-emitting lasers 3A to 3D, the interval (pitch) between the bright parts Pa formed in the passing region Ra can be easily and appropriately adjusted according to the size range of the sample S to be measured. The two or more surface-emitting lasers that emit the laser light L1 may be configured to be switchable by, for example, the control unit 5.

(Fourth Measurement Example)

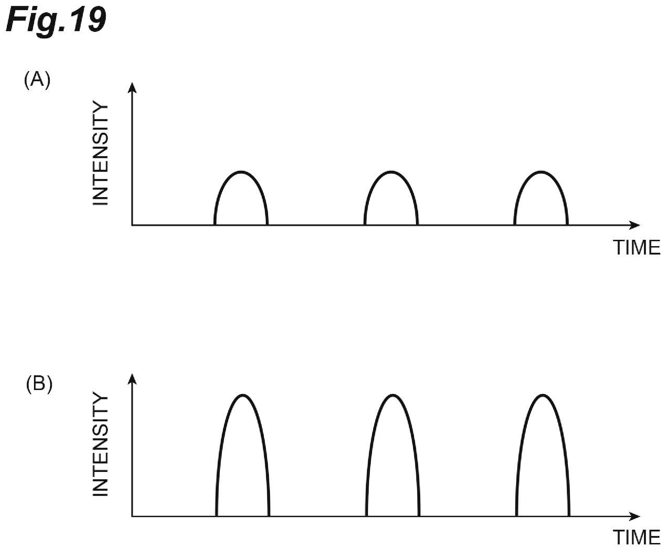

A fourth measurement example will be described with reference to FIGS. 18 and 19. The fourth measurement example is similar to the third measurement example in that a plurality of surface-emitting lasers (light source units) are used as light sources. In the fourth measurement example, the laser measurement device 1A includes two surface-emitting lasers 3A and 3B as light sources. Both of the surface-emitting lasers 3A and 3B have the same configuration as the surface-emitting laser 3 described above.

The plurality of surface-emitting lasers 3A and 3B are configured to form a first bright part Pa1 having a first intensity of brightness in a region R1 of a first range in the Y-axis direction (first direction) and form a second bright part Pa2 having a second intensity of brightness different from the first intensity in a region R2 of a second range different from the first range in the Y-axis direction, in at least a part of the region in the sample flow path 21. As an example, the first range is a region outside the central portion in the Y-axis direction, and the second range is a region of the central portion in the Y-axis direction. Further, one surface-emitting laser 3A is configured to form the low-intensity first bright part Pa1 in the region R1, and the other surface-emitting laser 3B is configured to form the high-intensity second bright part Pa2 in the region R2. That is, the light intensity of the laser light L1 of the surface-emitting laser 3B forming the second bright part Pa2 is made larger than the light intensity of the laser light L1 of the surface-emitting laser 3A forming the first bright part Pa1.

Both the first bright part Pa1 and the second bright part Pa2 are formed in a linear shape extending in the Y-axis direction when viewed from the X-axis direction. That is, the surface-emitting laser 3A forms a beam pattern PA in which the low-intensity first bright parts Pa1 and the dark parts Pb are alternately arranged along the Z-axis direction. On the other hand, the surface-emitting laser 3B forms a beam pattern PB in which the high-intensity second bright parts Pa2 and the dark parts Pb are alternately arranged along the Z-axis direction.

As shown in FIG. 18, a sample Sj passes through the region R1 in the sample flow path 21. A sample Sk passes through the region R2 in the sample flow path 21. The samples Sj and Sk have the same shape and size as each other. (A) of FIG. 19 is a graph showing a measurement result of the emitted light L2 from the sample Sj, and (B) is a graph showing a measurement result of the emitted light L2 from the sample Sk. In each graph, the horizontal axis indicates time, and the vertical axis indicates the signal intensity of the emitted light L2 detected by the photodetector 4.

As shown in FIG. 19, the signal intensity of the emitted light L2 emitted from the sample Sk passing through the high-intensity second bright part Pa2 ((B) of FIG. 19) is larger than the signal intensity of the emitted light L2 emitted from the sample Sj passing through the low-intensity first bright part Pa1 ((A) of FIG. 19). Therefore, according to the fourth measurement example, the control unit 5 can identify the region (either the region R1 or R2 in the example of FIG. 18) through which the sample S to be measured has passed in the sample flow path 21 based on the intensity of the emitted light L2 detected by the photodetector 4. For example, consider a case where it is necessary to control the flow in the flow cell 2 so that the sample S passes through the central portion (region R2) in the sample flow path 21 in order to measure the sample S with high precision. According to the fourth measurement example, in such a case, it is possible to easily confirm whether or not the flow control in the flow cell 2 is performed appropriately (that is, whether or not only the measurement result corresponding to the sample S passing through the region R2 is obtained).

(Fifth Measurement Example)

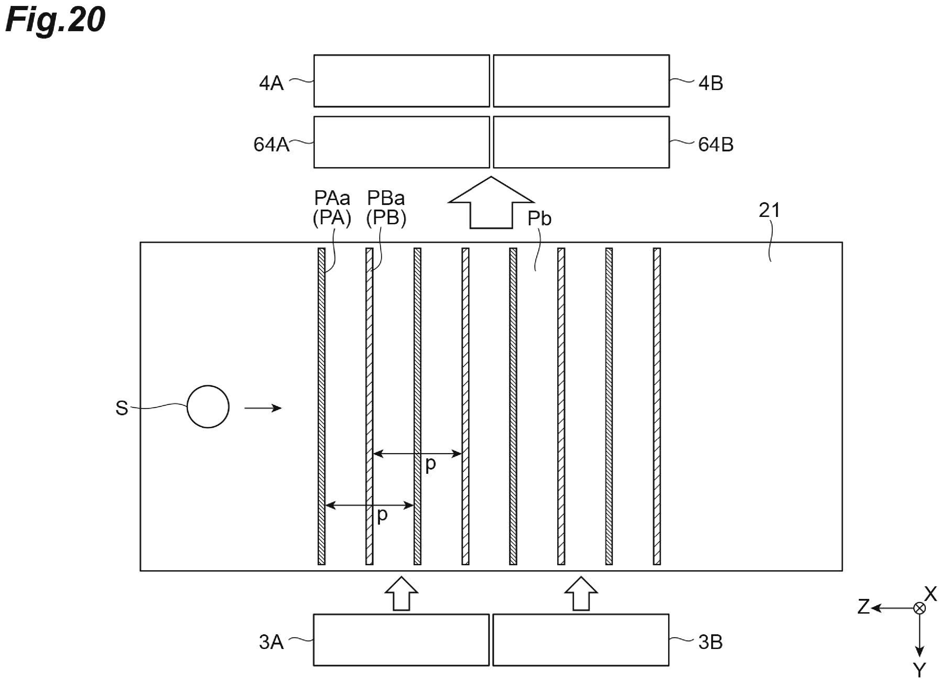

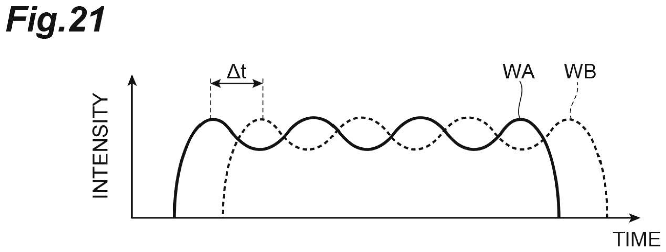

A fifth measurement example will be described with reference to FIGS. 20 and 21. In the fifth measurement example, the laser measurement device 1 includes two surface-emitting lasers 3A (first light source unit) and 3B (second light source unit) as light sources. The surface-emitting laser 3A is configured to emit laser light L1 of a first wavelength. The surface-emitting laser 3B is configured to emit laser light L1 of a second wavelength different from the first wavelength.

The wavelength of the emitted light L2 emitted from the sample S in response to irradiation with the laser light L1 of the first wavelength is a wavelength corresponding to the first wavelength (for example, the same wavelength as the first wavelength). Similarly, the wavelength of the emitted light L2 emitted from the sample S in response to irradiation with the laser light L1 of the second wavelength is a wavelength corresponding to the second wavelength (for example, the same wavelength as the second wavelength). Therefore, in the fifth measurement example, the laser measurement device 1 includes a photodetector 4A (first sensor) that detects a first signal corresponding to the emitted light L2 (first emitted light) emitted in response to the sample S being irradiated with the laser light L1 of the first wavelength, and a photodetector 4B (second sensor) that detects a second signal corresponding to the emitted light L2 (second emitted light) emitted in response to the sample S being irradiated with the laser light L1 of the second wavelength. Note that an optical filter 64A configured to transmit only the first emitted light may be arranged in front of the photodetector 4A. Similarly, an optical filter 64B configured to transmit only the second emitted light may be arranged in front of the photodetector 4B. By configuring in this way, the measurement result corresponding to the first wavelength (first signal) and the measurement result corresponding to the second wavelength (second signal) can be acquired separately.

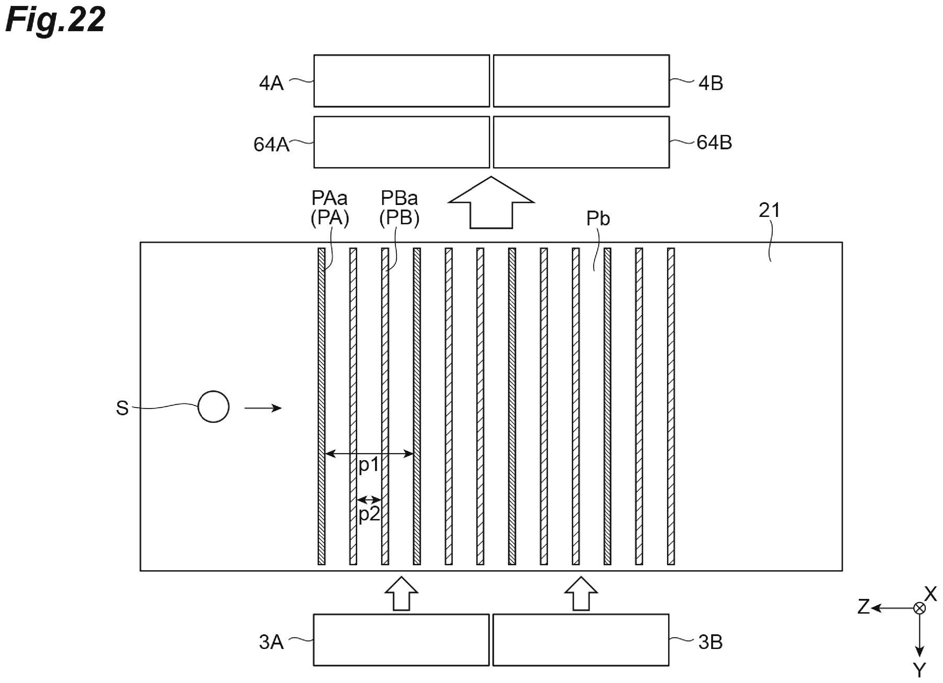

Note that the XYZ orthogonal coordinate system in FIG. 20 indicates the direction of the illustrated flow cell 2, and the arrangement of the surface-emitting lasers 3A and 3B and the photodetectors 4A and 4B in FIG. 20 does not correspond to the actual arrangement with respect to the flow cell 2. Actually, in FIG. 20, the surface-emitting lasers 3A and 3B are arranged on the back side of the paper surface relative to the flow cell 2, and the photodetectors 4A and 4B are arranged on the front side of the paper surface relative to the flow cell 2. The same applies to FIGS. 22 to 24.

As shown in FIG. 20, a beam pattern PA (first beam pattern) formed by the surface-emitting laser 3A and a beam pattern PB (second beam pattern) formed by the surface-emitting laser 3B have the same shape, and are arranged at positions shifted from each other along the Z-axis direction. In the example of FIG. 20, the beam pattern PA has a striped pattern shape in which four linear bright parts PAa are arranged at a pitch p. The beam pattern PB also has a striped pattern shape in which four linear bright parts PBa are arranged at a pitch p, similarly to the beam pattern PA. The beam pattern PB is shifted downstream by a distance of half the pitch p from the beam pattern PA.

FIG. 21 is a graph showing a waveform WA corresponding to a measurement result of the first emitted light emitted when the sample S passes through the beam pattern PA of the first wavelength (that is, a measurement result of the first emitted light detected by the photodetector 4A), and a waveform WB corresponding to a measurement result of the second emitted light emitted when the sample S passes through the beam pattern PB of the second wavelength (that is, a measurement result of the second emitted light detected by the photodetector 4B). In FIG. 21, the horizontal axis indicates time, and the vertical axis indicates the signal intensity of the emitted light L2 detected by each of the photodetectors 4A and 4B. As shown in FIG. 21, since the two beam patterns PA and PB have the same shape, waveforms WA and WB having the same shape are obtained. Further, since the beam pattern PB is located downstream of the beam pattern PA by half the pitch p, a time difference $\Delta t$ corresponding to the distance difference occurs between the waveform WA and the waveform WB.

According to the fifth measurement example, the control unit 5 can measure the velocity (flow velocity) of the sample S in the sample flow path 21 easily and with high precision based on the time lag (time difference $\Delta t$) between the waveform WA corresponding to the measurement result of the first wavelength (measurement result of the photodetector 4A) and the waveform WB corresponding to the measurement result of the second wavelength (measurement result of the photodetector 4B), and the positional shift amount between the beam pattern PA and the beam pattern PB (half of the pitch p in the example of FIG. 21). For example, the control unit 5 can calculate the time difference $\Delta t$ by performing pattern matching between the waveform WA and the waveform WB to obtain a relative movement amount of the waveform WB with respect to the waveform WA required to superimpose the waveform WA on the waveform WB. Alternatively, as shown in FIG. 21, points corresponding to each other in the waveforms WA and WB (for example, points corresponding to the first peak) may be identified, and the time difference $\Delta t$ between the points may be calculated. Then, the control unit 5 can easily and accurately obtain the flow velocity of the sample S during the measurement period of the waveforms WA and WB by dividing the positional shift amount (p/2) of the beam patterns PA and PB by the time difference $\Delta t$. Note that, for example, a plurality of (for example, two) light source units of the same wavelength may be prepared, configured such that beam patterns of each of the plurality of light source units are formed at positions shifted from each other along the Z-axis direction, light emission timings of each of the plurality of light source units may be made different from each other (for example, blinking alternately so that pulse light emission timings do not overlap), and outputs (signal intensities) of each of a plurality of photodetectors may be detected to perform measurement similar to the fifth measurement example. According to such a configuration, while control of light emission timing is required, it is possible to omit the optical filter arranged in front of the photodetector.

(Sixth Measurement Example)

A sixth measurement example will be described with reference to FIG. 22. The sixth measurement example differs from the fifth measurement example in the following points. That is, in the sixth measurement example, the surface-emitting laser 3A forms a beam pattern PA in which a plurality of linear bright parts PAa extending in the Y-axis direction are arranged at a first interval (pitch p1) along the Z-axis direction. On the other hand, the surface-emitting laser 3B forms a beam pattern PB in which a plurality of linear bright parts PBa extending in the Y-axis direction are arranged at a second interval (pitch p2) different from the first interval along the Z-axis direction. In the example of FIG. 22, the pitch p2 is 1/3 of the pitch p1. Therefore, in FIG. 22, the bright parts PBa are formed so as to overlap at positions where the bright parts PAa are formed.

According to the sixth measurement example, by making the pitch between the bright parts different for each wavelength (that is, by making the pitch p1 between adjacent bright parts PAa different from the pitch p2 between adjacent bright parts PBa), when samples S to be measured (that is, a sample group that may flow through the flow cell 2) have size ranges different from each other, it becomes possible to perform measurement of sample sizes corresponding to each size range based on the measurement result of each wavelength (that is, the measurement result of the photodetector 4A or the measurement result of the photodetector 4B). That is, according to the sixth measurement example, it is possible to simultaneously cope with both the size range measurable by the pitch p1 and the size range measurable by the pitch p2. In the third modification described above, the measurable size range can be adjusted (changed) by selecting a combination of the plurality of surface-emitting lasers 3A to 3D, but it is not possible to simultaneously cope with a plurality of different arbitrary size ranges. For example, also in the third modification, by combining the beam pattern PA and the beam pattern PC, two different pitches "p/4" and "3p/4" can be partially formed, but there is a limit to the combination of two realizable pitches (in the above example, even if the positions of the two beam patterns PA and PB are shifted, only a combination in which the sum of the two pitches is "p" can be realized). On the other hand, according to the sixth modification, since a beam pattern of an arbitrary pitch can be formed for each wavelength, it is possible to flexibly and simultaneously cope with two different size ranges.

(Seventh Measurement Example)

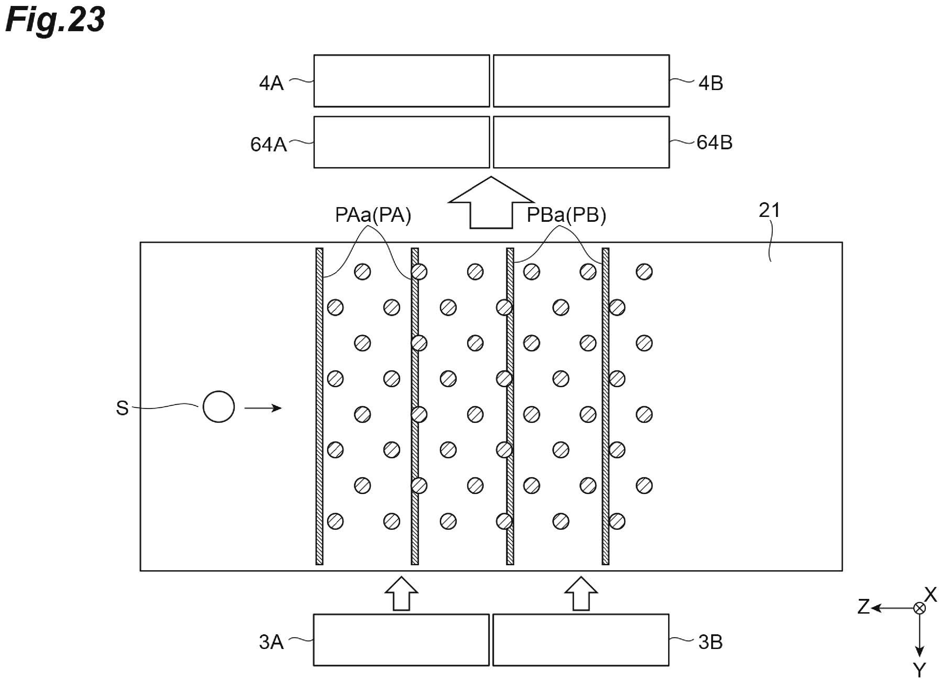

A seventh measurement example will be described with reference to FIG. 23. The seventh measurement example differs from the sixth measurement example in the following points. That is, in the seventh measurement example, the pattern shape of the beam pattern PA formed by the surface-emitting laser 3A (striped pattern in the example of FIG. 23) is different from the pattern shape of the beam pattern PB formed by the surface-emitting laser 3B (dot pattern in the example of FIG. 23). Here, the "pattern shape" means a type of shape of the bright parts constituting the beam pattern (for example, a type of pattern such as a line (stripe) shape, a point (dot) shape, etc.).

According to the seventh measurement example, since measurement results (time waveforms) corresponding to different pattern shapes for each wavelength can be obtained, it becomes possible to perform more advanced particle measurement (waveform analysis). More specifically, measurement results corresponding to the beam patterns PA and PB having different pattern shapes can be acquired simultaneously and distinctly by separating the wavelengths of the beam patterns PA and PB. In this way, by obtaining waveforms of each of a plurality of pattern shapes, the amount of information that can be used for waveform analysis can be increased.

(Eighth Measurement Example)

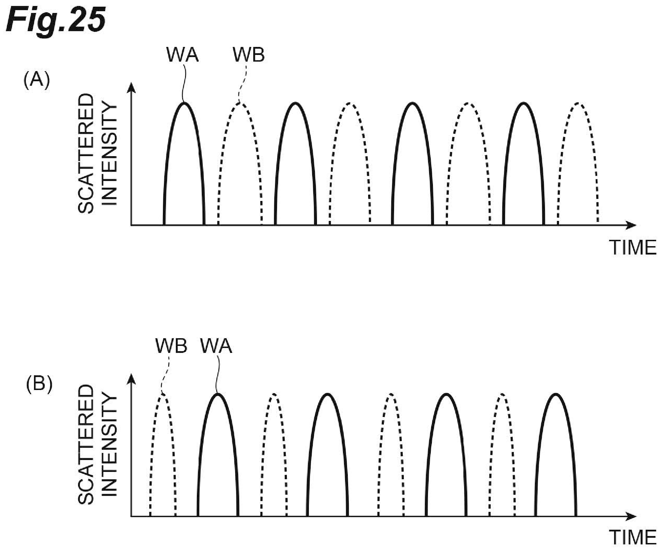

An eighth measurement example will be described with reference to FIGS. 24 and 25. The eighth measurement example is similar to the fifth to seventh measurement examples in that the surface-emitting laser 3A emitting the laser light L1 of the first wavelength and the surface-emitting laser 3B emitting the laser light L1 of the second wavelength are used as light sources. On the other hand, in the eighth measurement example, the surface-emitting laser 3A is configured to form a striped beam pattern PA in which a plurality of bright parts PAa extending in a first direction D1 intersecting the Z-axis direction are arranged along the Z-axis direction. The surface-emitting laser 3B is configured to form a striped beam pattern PB in which a plurality of bright parts PBa extending in a second direction D2 intersecting the first direction D1 are arranged along the Z-axis direction. As an example, the angle at which the first direction D1 is inclined with respect to the Z-axis direction is obtained by reversing the sign of the angle at which the second direction D2 is inclined with respect to the Z-axis direction. That is, the beam pattern PA and the beam pattern PB have a line-symmetric shape with respect to an axis AX parallel to the Z-axis direction.

According to the eighth measurement example, it becomes possible to perform more advanced shape estimation of the particle from the measurement result (time waveform) for each wavelength. Hereinafter, an example of the above shape estimation will be described with reference to FIGS. 24 and 25. Here, as shown in FIG. 24, a spherical sample S1 and a non-spherical (ellipsoidal) sample Sm are considered. (A) of FIG. 25 is a graph showing a waveform WA corresponding to a measurement result of the first emitted light emitted when the sample S1 passes through the beam pattern PA of the first wavelength (that is, a measurement result of the first emitted light detected by the photodetector 4A), and a waveform WB corresponding to a measurement result of the second emitted light emitted when the sample SI passes through the beam pattern PB of the second wavelength (that is, a measurement result of the second emitted light detected by the photodetector 4B). (B) of FIG. 25 is a graph showing a waveform WA corresponding to a measurement result of the first emitted light emitted when the sample Sm passes through the beam pattern PA of the first wavelength (that is, a measurement result of the first emitted light detected by the photodetector 4A), and a waveform WB corresponding to a measurement result of the second emitted light emitted when the sample Sm passes through the beam pattern PB of the second wavelength (that is, a measurement result of the second emitted light detected by the photodetector 4B).

In the case of the spherical sample SI (that is, a sample having a line-symmetric shape with respect to an axis parallel to the Z-axis direction), the time during which the sample S1 flowing in the sample flow path 21 overlaps with one bright part PAa (that is, the period during which the emitted light L2 detected by the photodetector 4A is emitted) is the same as the time during which the sample SI overlaps with one bright part PBa (that is, the period during which the emitted light L2 detected by the photodetector 4B is emitted). Therefore, as shown in (A) of FIG. 25, for the sample SI, waveforms WA and WB having the same shape as each other and shifted in time are observed.

On the other hand, in the case of a non-spherical sample like the sample Sm (a sample not having a line-symmetric shape with respect to an axis parallel to the Z-axis direction as shown in FIG. 24), the time during which the sample Sm flowing in the sample flow path 21 overlaps with one bright part PAa is not the same as the time during which the sample Sm overlaps with one bright part PBa. In the example of FIG. 24, the time during which the sample Sm overlaps with one bright part PBa is shorter than the time during which the sample Sm overlaps with one bright part PAa. Therefore, as shown in (B) of FIG. 25, for the sample Sm, the time width of the waveform WA is smaller than the time width of the waveform WB.

Therefore, in the above example, based on the waveforms WA and WB obtained by the photodetectors 4A and 4B, the control unit 5 can determine (estimate) that the sample S is spherical (or has a shape close to a sphere) when it can be determined that the time width of the waveform WA and the time width of the waveform WB are the same or similar according to a predetermined criterion. On the other hand, the control unit 5 can determine (estimate) that the sample S has a shape deviating from a sphere as the difference between the time width of the waveform WA and the time width of the waveform WB increases. Note that in the example of FIG. 24, when the sample Sm flows through the sample flow path 21 with the longitudinal direction of the sample Sm parallel to the Z-axis direction or the Y-axis direction, there is a possibility that the time width of the waveform WA and the time width of the waveform WB become the same for the sample Sm as well, similarly to the sample SI, but since it is considered rare for a non-spherical sample to flow through the sample flow path 21 while maintaining such a posture, it is considered that the shape of the sample (whether it is spherical or non-spherical) can be determined (estimated) with a certain degree of accuracy by the above measurement method.

(Ninth Measurement Example)

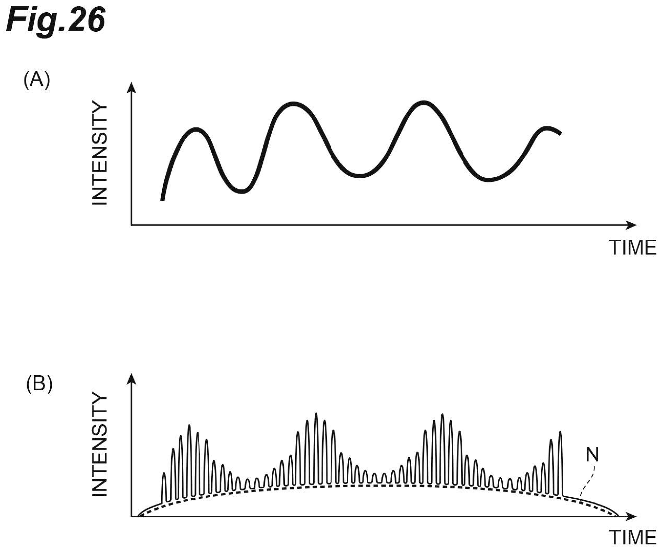

A ninth measurement example will be described with reference to FIGS. 26 to 28. In the ninth measurement example, the surface-emitting laser 3 is configured to temporally modulate the laser light L1. As an example, the surface-emitting laser 3 is configured to blink the laser light L1 by switching ON/OFF of the laser light L1. For example, the surface-emitting laser 3 blinks the laser light L1 forming the beam pattern P1 similar to that of the first measurement example (FIG. 12) at a predetermined frequency. Note that in the ninth measurement example, it is not necessarily configured to switch between an ON state of the laser light L1 (a state in which the laser light L1 having a predetermined intensity is output) and an OFF state (a state in which the intensity is 0%, that is, a state in which the laser light L1 is not output). For example, the surface-emitting laser 3 may be configured such that the laser light L1 is always emitted, and a period in which the intensity is sufficiently strong (corresponding to the ON state) and a state in which the intensity is sufficiently low (corresponding to the OFF state) are temporally modulated.

(A) of FIG. 26 is a graph showing a measurement result of the emitted light L2 when the laser light L1 is not blinked. (B) of FIG. 26 is a graph showing a measurement result of the emitted light L2 of the ninth modification (that is, when the laser light L1 is blinked). Here, constant background noise is generated during both measurements. It is difficult to identify the background noise from the time waveform shown in (A) of FIG. 26. On the other hand, in the time waveform shown in (B) of FIG. 26, background noise N can be easily measured by connecting the lower ends of each waveform element measured in a pulse shape.

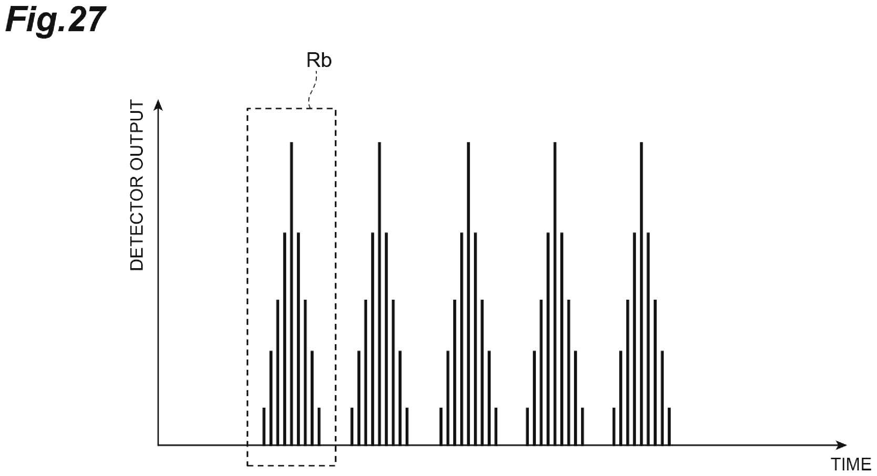

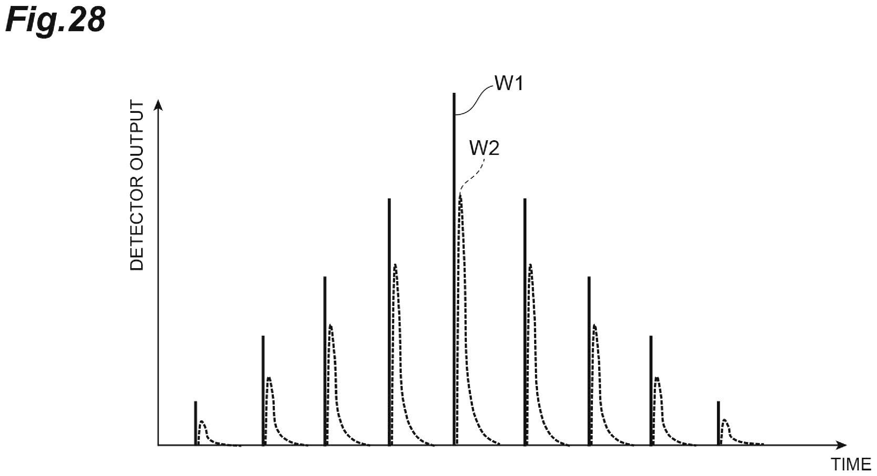

FIG. 27 is a graph showing a measurement result of the emitted light L2 when the blinking frequency is 20 kHz (light emission interval: 50 $\mu$s), the pitch between the bright parts Pa of the beam pattern P1 (see FIG. 12) is set to 5 $\mu$m, and the laser light L1 is made into short pulses (when one pulse width is set to several ns). FIG. 28 is an enlarged view showing a range Rb in FIG. 27. Note that in the example of FIG. 27, background noise does not exist or is negligibly small. When the laser light L1 is made into short pulses in this way, as shown in FIG. 28, it becomes possible to obtain a measurement value W1 corresponding to the emitted light L2 and a measurement value W2 corresponding to delayed fluorescence of the sample S by the photodetector 4. That is, it becomes possible to simultaneously measure the emitted light L2 (forward scattered light) and the delayed fluorescence. As a result, when performing fluorescence measurement (that is, when delayed fluorescence is the measurement target), background light derived from excitation light (laser light L1) and delayed fluorescence to be measured can be measured separately, so that the detection limit of fluorescence measurement can be improved. Further, the control unit 5 can perform measurement of the sample size as described above based on the detection result (measurement value W1) of the emitted light L2, and can also perform identification of the sample S based on the fluorescence lifetime obtained from the measurement value W2 of the delayed fluorescence. Further, by using the striped beam pattern P1 as in this example, measurement results similar to the range Rb in FIG. 27 can be obtained for the number of stripes. By integrating and averaging the measurement values W2 repeatedly measured a plurality of times in this way, it becomes possible to calculate the fluorescence lifetime with high accuracy.

[Functions and Effects]

In the laser measurement device 1 described above, the beam pattern P in which the bright parts Pa and the dark parts Pb are alternately arranged along the flow direction (Z-axis direction) of the flow cell 2 is formed in the sample flow path 21 of the flow cell 2. Particle measurement (for example, measurement of the size of the sample S, etc.) can be suitably performed based on the emitted light L2 (forward scattered light in the present embodiment) emitted from the sample S to be measured when the sample S is caused to pass through the region where such a beam pattern P is formed. Furthermore, according to the laser measurement device 1, by using a single light source (surface-emitting laser 3) configured to form the beam pattern P (for example, the striped beam pattern P1 of FIG. 12) in advance, the beam pattern P can be formed with high precision and ease. That is, in order to form the beam pattern P, it is not necessary to perform sophisticated and complicated alignment adjustment of a plurality of light sources (that is, optical axes of laser beams emitted from respective light sources) or an optical member such as a beam splitter for splitting one laser beam emitted from one light source into two laser beams. As described above, according to the laser measurement device 1, the beam pattern P suitable for particle measurement using the flow cell 2 can be formed with high precision and ease.

Further, by using the surface-emitting laser 3 having the phase modulation layer 15 as the light source, the above-described beam pattern P can be suitably and easily formed in the sample flow path 21. In the present embodiment, in the surface-emitting laser 3, the center of gravity G of each of the plurality of different refractive index regions 15b is arranged at a relative position according to a phase distribution corresponding to the beam pattern P with respect to each of the plurality of lattice points O arranged periodically. That is, the surface-emitting laser 3 is configured as an iPMSEL. According to the above configuration, the beam pattern P can be suitably and easily formed in the sample flow path 21 by the surface-emitting laser 3 while making a slit member 50 used in a modification of the light source described later unnecessary.

The light source (surface-emitting lasers 3, 3A to 3D) is fixed to the side wall 22 (one side surface 22a in the present embodiment) of the flow cell 2. According to the above configuration, attenuation of the laser light L1 outside the flow cell 2 can be suppressed. Further, positioning of the surface-emitting lasers 3, 3A to 3D with respect to the flow cell 2 can be facilitated, and the laser measurement device 1 (module) can be miniaturized.

Note that in the method described in Patent Literature 1, it is necessary to make two laser beams parallel light before making them incident on the flow cell, but since a certain optical path length is required to make the laser light from the light source parallel light, there is a possibility that the measurement device becomes large. On the other hand, in the present embodiment, by using the surface-emitting laser 3 to which the first example and the second example of the phase distribution described above are applied as the light source, it becomes possible to form a fine striped beam pattern P1 in a space relatively close (for example, about 1 mm) to the light emission surface 3a. Thereby, even if the distance from the light emission surface 3a to the sample flow path 21 is shortened by fixing the surface-emitting laser 3 to the side wall 22 of the flow cell 2, the fine striped beam pattern P1 can be appropriately formed in the sample flow path 21. That is, according to the present embodiment, the laser measurement device 1 can be miniaturized while easily and highly accurately forming a fine striped beam pattern in the sample flow path 21.

In the third to eighth measurement examples, the light source includes a plurality of surface-emitting lasers 3A to 3D (in the fifth to eighth measurement examples, two surface-emitting lasers 3A and 3B). These plurality of surface-emitting lasers (light source units) are arranged along the flow direction (Z-axis direction). According to the above configuration, by combining beam patterns of each of the plurality of surface-emitting lasers, a beam pattern capable of performing more advanced particle measurement (for example, measurement of the third to eighth measurement examples described above) than particle measurement possible with a beam pattern of a single surface-emitting laser can be formed in the flow cell 2. Further, by arranging the plurality of surface-emitting lasers along the Z-axis direction, a mounting surface of the surface-emitting lasers 3A to 3D with respect to the flow cell 2 (one side surface 22a of the side wall 22 in the present embodiment) can be made common, so that the laser measurement device 1 (module) can be made compact.

Further, as in the fifth to eighth measurement examples, according to the configuration including the surface-emitting laser 3A emitting the laser light L1 of the first wavelength and the surface-emitting laser 3B emitting the laser light L1 of the second wavelength as light sources, and including the photodetector 4A corresponding to the surface-emitting laser 3A and the photodetector 4B corresponding to the surface-emitting laser 3B as sensors, more advanced particle measurement can be performed based on measurement results corresponding to each of a plurality of wavelengths different from each other. Note that in the above embodiment (fifth to eighth measurement examples), the laser measurement device 1 includes a plurality (two) of photodetectors 4A and 4B physically different for each wavelength, but the laser measurement device 1 may include a single photodetector capable of distinctly detecting measurement results (first signal and second signal) for each wavelength. Examples of such a photodetector include a sensor combining a plurality of pixels and a filter configured such that transmission wavelengths are different for each pixel.

Further, by utilizing the laser measurement device 1, the following laser measurement method can be suitably implemented. That is, the laser measurement method includes a first step of forming a beam pattern P in which at least two bright parts Pa are arranged with a dark part Pb interposed therebetween along a flow direction (Z-axis direction) of a fluid in a sample flow path 21 through which the fluid containing a sample S to be measured passes in the flow cell 2, by emitting laser light L1 from the surface-emitting laser 3 to the flow cell 2, a second step of detecting emitted light L2 emitted from the sample S when the sample S passes through a region where the beam pattern P is formed, and a third step of determining at least one of a shape and a size of the sample S based on the detected emitted light L2. When the laser measurement device 1 is used, detection of the emitted light L2 in the second step is executed by the photodetector 4. Further, the determination process in the third step is executed by the control unit 5. According to the above laser measurement method, since the beam pattern P suitable for particle measurement using the flow cell 2 can be formed with high precision and ease by the surface-emitting laser 3, at least one of the shape and the size of the particle can be determined with high accuracy based on the detection result of the emitted light L2 obtained by the beam pattern P.

[Modifications]

Although some embodiments and some modifications of the present disclosure have been described above, the present disclosure is not limited to the configurations shown in the above embodiments and modifications. The material and shape of each configuration are not limited to the specific materials and shapes described above, and various materials and shapes other than those described above can be adopted. Further, some configurations included in the above embodiments and modifications may be omitted or changed as appropriate, or may be arbitrarily combined.

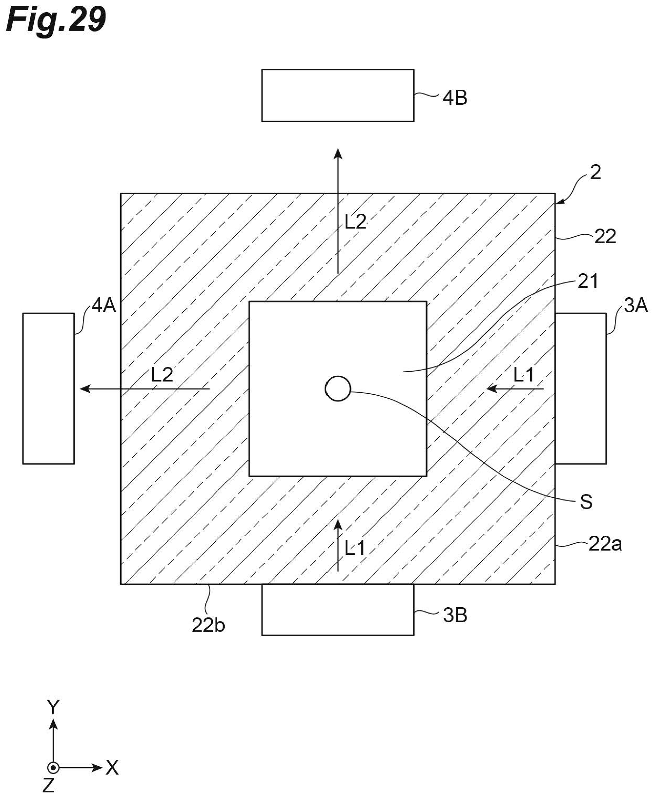

In the third to eighth measurement examples, the configuration using the plurality of surface-emitting lasers 3A to 3D as light sources has been described, but the arrangement method of the plurality of surface-emitting lasers 3A to 3D is not limited to the method of arranging them along the Z-axis direction on the same side surface 22a of the side wall 22 as shown in FIG. 16. For example, as shown in FIG. 29, a plurality (two here) of surface-emitting lasers 3A and 3B may be arranged along a direction intersecting the Z-axis direction (for example, an outer circumferential direction of the side wall 22 orthogonal to the Z-axis direction). In this way, the plurality (two) of surface-emitting lasers 3A and 3B may be provided on side surfaces 22a and 22b different from each other of the side wall 22 (in this example, adjacent side surfaces orthogonal to each other). Further, when detecting forward scattered light from the sample S as the emitted light L2 as in the above embodiment, the photodetector 4A for detecting the forward scattered light (emitted light L2) emitted from the sample S by the laser light L1 (beam pattern) from the surface-emitting laser 3A may be arranged at a position facing the surface-emitting laser 3A with the flow cell 2 interposed therebetween. Similarly, the photodetector 4B for detecting the forward scattered light (emitted light L2) emitted from the sample S by the laser light L1 (beam pattern) from the surface-emitting laser 3B may be arranged at a position facing the surface-emitting laser 3B with the flow cell 2 interposed therebetween. According to the above configuration, by distributing and arranging the plurality of surface-emitting lasers around the sample flow path 21, the degree of freedom in arrangement of the surface-emitting lasers can be improved.

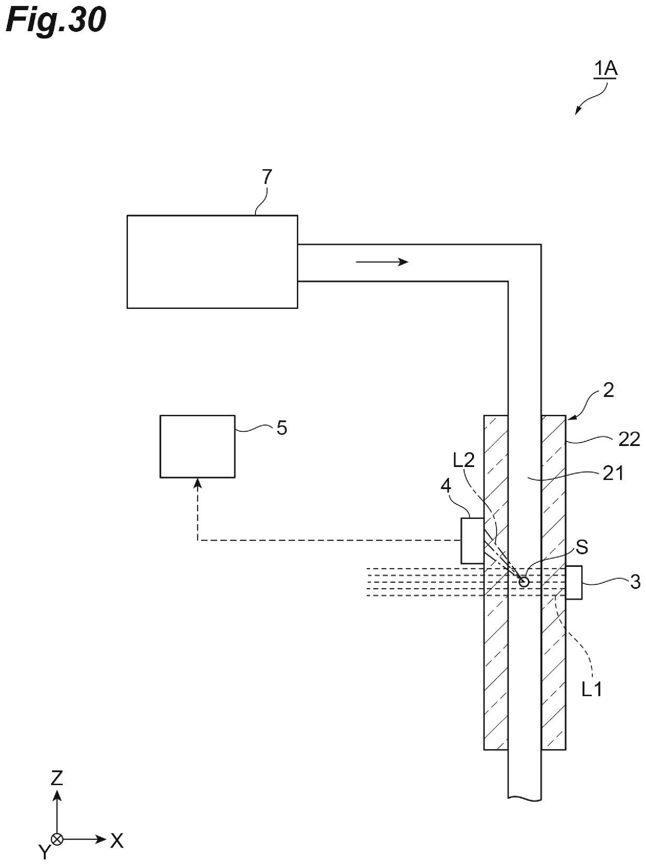

FIG. 30 is a schematic diagram showing a configuration of a laser measurement device 1A according to a first modification. Like the laser measurement device 1A, the photodetector 4 may be arranged at a position shifted in the Z-axis direction from a front position of the surface-emitting laser 3 (that is, a position where the laser light L1 is incident). Even in this case, a part of the forward scattered light (emitted light L2) radiated at a constant radiation angle can be detected by the photodetector 4. Further, in order to improve light receiving efficiency in the photodetector 4, the photodetector 4 may be fixed to the side wall 22 of the flow cell 2. According to the above configuration, the optical system 6 in the laser measurement device 1 of FIG. 1 can be omitted, and by fixing the photodetector 4 to the flow cell 2, further miniaturization of the laser measurement device 1A (module) can be achieved.

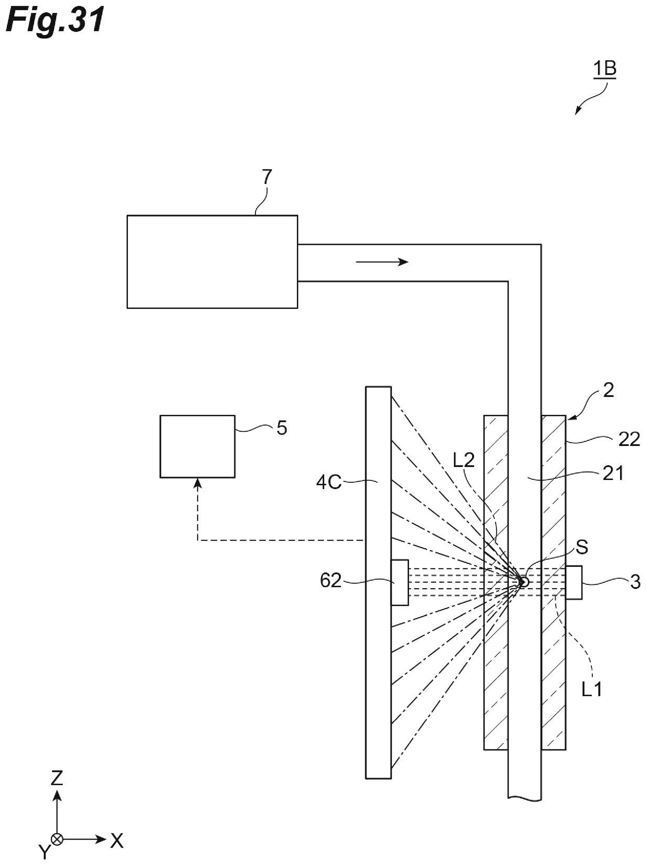

FIG. 31 is a schematic diagram showing a configuration of a laser measurement device 1B according to a second modification. The laser measurement device 1B includes a photodetector 4C having a light receiving surface with a larger area than the laser measurement devices 1 and 1A. More specifically, the photodetector 4C has a light receiving surface with a larger area than the light shielding plate 62 for shielding the laser light L1. As an example, the photodetector 4C has a light receiving surface located outside the light shielding plate 62 when viewed from the X-axis direction. Further, the photodetector 4C is arranged at a position away from the flow cell 2, similarly to the photodetector 4 of the laser measurement device 1. According to the laser measurement device 1B, the emitted light L2 traveling while spreading at a relatively large angle can be detected by the photodetector 4C at a position relatively far from the sample S and where the laser light L1 and the emitted light L2 do not overlap. Thereby, compared with the laser measurement device 1A of the first modification, the amount of received light of the emitted light L2 by the photodetector 4C can be increased. Further, according to the laser measurement device 1B, similarly to the laser measurement device 1A, since the optical system 6 other than the light shielding plate 62 in the laser measurement device 1 can be omitted, further miniaturization of the laser measurement device 1B (module) can be achieved.

In the above embodiment, a striped (linear) pattern and a dot-shaped (point-like) pattern have been exemplified as the pattern shape of the beam pattern formed in the sample flow path 21, but the pattern shape of the beam pattern is not limited to the above two shapes. For example, like a beam pattern PM1 in (A) of FIG. 32, a beam pattern having a shape in which a plurality of bright parts Pa extending in the Y-axis direction with bent portions C instead of a linear shape are arranged along the Z-axis direction may be used. Further, like a beam pattern PM2 in (B) of FIG. 32, a beam pattern of a striped pattern having bright parts Pa configured such that curvature gradually changes toward the downstream side may be used. According to such a beam pattern PM2, it is possible to correct a flow velocity difference between the central portion and the outer edge portion of the sample flow path 21 in the Y-axis direction, and obtain a signal purely dependent only on the size (particle diameter) of the sample S regardless of which position in the Y-axis direction of the sample flow path 21 the sample S passes through.

In the above embodiment, forward scattered light emitted from the sample S in response to irradiation with the laser light L1 is detected as the emitted light L2, but light other than scattered light (for example, fluorescence) may be detected as the emitted light L2, or side scattered light may be detected as the emitted light L2. Note that when side scattered light is detected as the emitted light L2, the photodetector 4 may be arranged in the emission direction of the side scattered light with respect to the sample S, not at a position facing the surface-emitting laser 3. Further, while detecting forward scattered light as the emitted light L2 for determining the shape or size of the particle, side scattered light may be detected together as information for analyzing the type of particle. In this case, a photodetector for detecting side scattered light may be provided separately from the photodetector 4 for detecting the emitted light L2 (forward scattered light).

In the above embodiment, a flow cell has been exemplified as an example of the flow path device, but the flow path device may include a micro flow path (sample flow path) other than a flow cell, such as a micro flow path chip used in fields such as μTAS.

Further, in the above embodiment, the configuration using the surface-emitting laser 3 configured as an iPMSEL as a light source (when the light source includes a plurality of light source units, each light source unit) has been described, but the light source may be realized by a combination of a surface-emitting laser other than an iPMSEL and a slit member. That is, in the above embodiment, as an example of the surface-emitting laser 3, a configuration in which a pseudo double slit is realized by the first region 151 and the second region 152 (see FIG. 9) and interference fringes due to interference of emitted light are formed has been described, but such a double slit may be realized by a physical slit member. Hereinafter, modifications of the light source using such a mechanism (first modification and second modification) will be described.

(First Modification of Light Source)

A first modification of the light source (combination of a surface-emitting laser 31 and a slit member 50) will be described with reference to FIG. 33. As shown in FIG. 33, the surface-emitting laser 31 has a configuration similar to that of the surface-emitting laser 3 shown in FIG. 6, but mainly differs from the surface-emitting laser 3 in the following points. That is, the surface-emitting laser 31 includes a phase modulation layer 15A instead of the phase modulation layer 15. Further, a slit member 50 is provided at a position facing the light emission surface 3a of the surface-emitting laser 31. In this example, the slit member 50 is provided integrally with the surface-emitting laser 31 on the antireflection film 19 provided on the back surface 10b in the opening 17a of the electrode 17.

As described above, in the phase modulation layer 15, the center of gravity G of each of the plurality of different refractive index regions 15b is arranged at a relative position according to a phase distribution corresponding to the beam pattern P with respect to each of the plurality of lattice points O arranged periodically. On the other hand, the phase modulation layer 15A is configured as a photonic crystal layer in which a plurality of different refractive index regions 15b are arranged periodically. That is, in the phase modulation layer 15A, the center of gravity G of each of the plurality of different refractive index regions 15b coincides with the position of each of the plurality of lattice points O arranged periodically. In other words, the surface-emitting laser 31 is configured as a Photonic Crystal Surface Emitting Laser (PCSEL) that emits coherent (longitudinal and lateral single mode) light from the back surface 10b.

The slit member 50 is a member for forming laser light L1 having a predetermined beam pattern P by passing light emitted from the surface-emitting laser 31. In the example of FIG. 33, the slit member 50 is a plate-like member having two openings 50a and 50b (slits). That is, in the example of FIG. 33, instead of the double slit formed in a pseudo manner by the first region 151 and the second region 152 (see FIG. 9), a double slit is realized by the openings 50a and 50b of the physical slit member 50. Thereby, the first modification of the light source (surface-emitting laser 31 and slit member 50) is configured to form interference fringes due to interference of emitted light passing through each opening 50a, 50b (for example, the striped beam pattern P1 according to the first measurement example shown in FIG. 12).

According to the first modification of the light source described above, the above-described beam pattern (striped beam pattern P1 as an example) can be suitably and easily formed in the sample flow path 21 by a combination of the surface-emitting laser 31 (PCSEL) and the slit member 50. Note that the number and shape of openings provided in the slit member 50 may be set according to the shape of a desired beam pattern. Further, in the example of FIG. 33, the surface-emitting laser 31 is formed integrally with the slit member 50, but the surface-emitting laser 31 and the slit member 50 may be arranged so as to be separated from each other as in a second modification of the light source shown in FIG. 34.

(Second Modification of Light Source)

A second modification of the light source (combination of a surface-emitting laser 32 and a slit member 50) will be described with reference to FIG. 34. The surface-emitting laser 32 is configured as a vertical cavity surface-emitting laser (VCSEL). As shown in FIG. 34, the surface-emitting laser 32 has a semiconductor substrate 321, a first DBR layer 322, an active layer 323, and a second DBR layer 327 instead of the semiconductor substrate 10, the cladding layer 11, the active layer 12, the cladding layer 13, the contact layer 14, and the phase modulation layer 15 included in the surface-emitting laser 3. The semiconductor substrate 321 is, for example, an n-type semiconductor substrate. The first DBR layer 322 is a layer composed of, for example, an n-type distributed Bragg reflector (DBR), and is formed on the semiconductor substrate 321. The active layer 323 is arranged between the first DBR layer 322 and the second DBR layer 327, and has a first guide layer 324, a quantum well layer 325, and a second guide layer 326 from the first DBR layer 322 side toward the second DBR layer 327 side. The second DBR layer 327 is a layer composed of, for example, a P-type distributed Bragg reflector (DBR), and is formed on the active layer 323.

The surface-emitting laser 32 as a VCSEL configured in this way also emits coherent light from a region within the opening 17a of the electrode 17 on the back surface (surface on which the antireflection film 19 is provided) of the semiconductor substrate 321, similarly to the surface-emitting laser 31. The width of the opening 17a is set to, for example, several $\mu$m or less in order to emit such coherent light. Further, a current confinement structure for suitably emitting coherent light may be formed in the surface-emitting laser 32.

The slit member 50 is a plate-like member in which double slits (openings 50a, 50b) similar to those of the first modification described above are formed. In the second modification, as an example, the surface-emitting laser 32 and the slit member 50 are arranged so as to be separated from each other. In order to form the striped beam pattern P1 as described above, the distance between the emission surface of the surface-emitting laser 32 (surface of the electrode 17 opposite to the semiconductor substrate 321 side) and the slit member 50 may be set to, for example, about several hundred $\mu$m.

According to the first modification or the second modification of the light source described above, a predetermined beam pattern (for example, striped beam pattern P1) can be suitably and easily formed by a combination of the surface-emitting laser (PCSEL or VCSEL) and the slit member 50.

Further, the configuration of the surface-emitting laser 3 configured as an iPMSEL (particularly, the configuration of each different refractive index region 15b) is not limited to the configuration described in the above embodiment. Hereinafter, other configuration examples of the surface-emitting laser 3 will be described in detail.

FIG. 35 is a plan view showing an example in which a refractive index substantially periodic structure is applied within a specific region of the phase modulation layer 15 shown in FIG. 11. In the example shown in FIG. 35, a substantially periodic structure for emitting a desired optical image (for example, the structure shown in FIG. 7) is formed inside a square inner region RIN. On the other hand, in an outer region ROUT surrounding the inner region RIN, perfect circular different refractive index regions 15b whose center of gravity positions coincide with lattice point positions of a square lattice are arranged. Inside the inner region RIN and in the outer region ROUT, lattice spacings a of virtually set square lattices are the same as each other. In the case of the structure shown in FIG. 38, since light is distributed also in the outer region ROUT, generation of high-frequency noise (so-called window function noise) caused by a sudden change in light intensity at the peripheral portion of the inner region RIN can be suppressed. Further, light leakage in a direction perpendicular to the thickness direction can be suppressed, and reduction of threshold current can be expected. Note that the present disclosure is not limited to this example, and a substantially periodic structure for emitting a desired optical image (for example, the structure shown in FIG. 7) may be formed in the entire region of the first region 151 and the second region 152.

In order to obtain a distribution of desired condensing points U, a rotation angle distribution $\alpha(x, y)$ of the different refractive index regions 15b in the phase modulation layer 15 (first region 151 and second region 152) is determined by the following procedure.

As a first precondition, in an XYZ orthogonal coordinate system defined by a Z axis coinciding with a normal direction and an X-Y plane coinciding with one surface of the phase modulation layer 15 including the plurality of different refractive index regions 15b, a virtual square lattice composed of $M_1 \times N_1$ ($M_1$, $N_1$ are integers of 1 or more) unit configuration regions R having a square shape is set on the X-Y plane.

As a second precondition, it is assumed that coordinates $(\xi, \eta, \zeta)$ in the XYZ orthogonal coordinate system satisfy the relationships shown in the following equations (1) to (3) with respect to spherical coordinates (r, $\theta_{rot}$, $\theta_{tilt}$) defined by a length r of a radius vector, a tilt angle $\theta_{tilt}$ from the Z axis, and a rotation angle $\theta_{rot}$ from the X axis specified on the X-Y plane, as shown in FIG. 36. FIG. 36 is a diagram for explaining coordinate conversion from spherical coordinates (r, $\theta_{rot}$, $\theta_{tilt}$) to coordinates ($\xi$, $\eta$, $\zeta$) in the XYZ orthogonal coordinate system, and a designed optical image on a predetermined plane set in the XYZ orthogonal coordinate system which is a real space is expressed by the coordinates ($\xi$, $\eta$, $\zeta$).

[Equation 1]

$$\xi = r \sin\theta_{tilt} \cos\theta_{rot} \quad \cdots \quad (1)$$

[Equation 2]

$$\eta = r \sin\theta_{tilt} \sin\theta_{rot} \quad \cdots \quad (2)$$

[Equation 3]

$$\zeta = r \cos\theta_{tilt} \quad \cdots \quad (3)$$

When light emitted from the surface-emitting laser 3 is a set of bright spots directed in directions defined by angles $\theta_{tilt}$ and $\theta_{rot}$, the angles $\theta_{tilt}$ and $\theta_{rot}$ are converted into a coordinate value kx on a $K_x$ axis corresponding to the X axis, which is a normalized wavenumber defined by the following equation (4), and a coordinate value ky on a $K_y$ axis corresponding to the Y axis and orthogonal to the $K_x$ axis, which is a normalized wavenumber defined by the following equation (5). The normalized wavenumber means a wavenumber normalized by setting a wavenumber $2\pi/a$ corresponding to the lattice spacing of the virtual square lattice to "1.0". At this time, in a wavenumber space defined by the $K_x$ axis and the $K_y$ axis, a specific wavenumber range including a beam pattern corresponding to an optical image is composed of $M_2 \times N_2$ ($M_2$, $N_2$ are integers of 1 or more) image regions FR each having a square shape. Note that the integer $M_2$ does not need to match the integer $M_1$. Similarly, the integer $N_2$ does not need to match the integer $N_1$. Equations (4) and (5) are disclosed in, for example, Non-Patent Literature 1.

[Equation 4]

$$k_x = \frac{a}{\lambda} \sin\theta_{tilt} \cos\theta_{rot} \quad \cdots \quad (4)$$

[Equation 5]

$$k_y = \frac{a}{\lambda} \sin\theta_{tilt} \sin\theta_{rot} \quad \cdots \quad (5)$$

a: Lattice constant of virtual square lattice
$\lambda$: Oscillation wavelength of surface-emitting laser 3

As a third precondition, a complex amplitude F(x, y) obtained by performing two-dimensional inverse discrete Fourier transform on each image region FR(kx, ky) specified by a coordinate component kx (integer of 0 or more and $M_2$-1 or less) in the $K_x$ axis direction and a coordinate component ky (integer of 0 or more and $N_2$-1 or less) in the $K_y$ axis direction in the wavenumber space into a unit configuration region R(x, y) on the X-Y plane specified by a coordinate component x (integer of 0 or more and $M_1$-1 or less) in the X axis direction and a coordinate component y (integer of 0 or more and $N_1$-1 or less) in the Y axis direction is given by the following equation (6), where j is an imaginary unit. The complex amplitude F(x, y) is defined by the following equation (7) when an amplitude term is A(x, y) and a phase term is $\phi$(x, y). As a fourth precondition, the unit configuration region R(x, y) is defined by an s axis and a t axis that are parallel to the X axis and the Y axis, respectively, and are orthogonal at a lattice point O(x, y) that is the center of the unit configuration region R(x, y).

[Equation 6]

$$F(x,y) = \sum_{k_x=0}^{M2-1} \sum_{k_y=0}^{N2-1} FR(k_x,k_y) \exp\left[ j2\pi\left( \frac{k_x}{M2}x + \frac{k_y}{N2}y \right) \right] \quad \cdots \quad (6)$$

[Equation 7]

$$F(x,y) = A(x,y) \times \exp\left[ j\phi(x,y) \right] \quad \cdots \quad (7)$$

Under the first to fourth preconditions, the first region 151 and the second region 152 may be configured to satisfy the following fifth condition and sixth condition. That is, the fifth condition is satisfied by arranging the center of gravity G in a state separated from the lattice point O(x, y) within the unit configuration region R(x, y). The sixth condition is satisfied by arranging the corresponding different refractive index region 15b in the unit configuration region R(x, y) such that an angle $\alpha(x, y)$ formed by a line segment connecting the lattice point O(x, y) and the corresponding center of gravity G and the s axis satisfies the following relationship in a state where a line segment length $r_2(x, y)$ from the lattice point O(x, y) to the corresponding center of gravity G is set to a common value in each of the $M_1 \times N_1$ unit configuration regions R.

$$\alpha(x, y) = C \times \phi(x, y) + B$$

C: Proportional constant, for example, $180°/\pi$
B: Arbitrary constant, for example, 0

Next, M-point oscillation of the surface-emitting laser 3 will be described. For M-point oscillation of the surface-emitting laser 3 (that is, for oscillation at the M-point band edge), it is preferable that the lattice spacing a of the virtual square lattice, the emission wavelength $\lambda$ of the active layer 12, and the equivalent refractive index n of the mode satisfy a condition such as $\lambda = (\sqrt{2})n \times a$. FIG. 37 is a plan view showing a reciprocal lattice space regarding a phase modulation layer of a light emitting device that performs M-point oscillation. Points P in the figure represent reciprocal lattice points. An arrow B1 in the figure represents a basic reciprocal lattice vector, and arrows K1, K2, K3, and K4 represent four in-plane wave vectors. The in-plane wave vectors K1 to K4 each have a wavenumber spread SP due to the rotation angle distribution $\alpha(x, y)$.

The magnitude of the in-plane wave vectors K1 to K4 (that is, the magnitude of the standing wave in the in-plane direction) is smaller than the magnitude of the basic reciprocal lattice vector B1. Therefore, the vector sum of the in-plane wave vectors K1 to K4 and the basic reciprocal lattice vector B1 does not become 0, and the wavenumber in the in-plane direction cannot become 0 due to diffraction, so diffraction in the plane vertical direction (Z-axis direction) does not occur. In this state, in the surface-emitting laser 3 of M-point oscillation, not only zero-order light in the plane vertical direction (Z-axis direction) but also +1st-order light and -1st-order light in directions inclined with respect to the Z-axis direction are not output.

For example, by applying the following contrivance to the phase modulation layer 15 (first region 151 and second region 152) in the surface-emitting laser 3 of M-point oscillation, it is possible to output a part of +1 st-order light and -1 st-order light without outputting zero-order light. That is, as shown in FIG. 38, by adding a diffraction vector V1 having a certain magnitude and direction to the in-plane wave vectors K1 to K4, the magnitude of at least one of the in-plane wave vectors K1 to K4 (in-plane wave vector K3 in the figure) is made smaller than $2\pi/\lambda$ ($\lambda$: wavelength of light output from the active layer 12). In other words, at least one of the in-plane wave vectors K1 to K4 after the diffraction vector V1 is added is contained within a light line LL which is a circular region with a radius of $2\pi/\lambda$.

In FIG. 38, in-plane wave vectors K1 to K4 shown by broken lines represent those before addition of the diffraction vector V1, and in-plane wave vectors K1 to K4 shown by solid lines represent those after addition of the diffraction vector V1. The light line LL corresponds to a total reflection condition, and a wave vector having a magnitude contained within the light line LL has a component in the plane vertical direction (Z-axis direction). In one example, the direction of the diffraction vector V1 is along the $\Gamma$-M1 axis or the $\Gamma$-M2 axis. The magnitude of the diffraction vector V1 is in the range of $2\pi/(\sqrt{2})a - 2\pi/\lambda$ to $2\pi/(\sqrt{2})a + 2\pi/\lambda$, and is $2\pi/(\sqrt{2})a$ in one example.

Subsequently, the magnitude and direction of the diffraction vector V1 for containing at least one of the in-plane wave vectors K1 to K4 within the light line LL will be examined. The following equations (8) to (11) show the in-plane wave vectors K1 to K4 before the diffraction vector V1 is added.

[Equation 8]

$$K1=\left(\frac{\pi}{a}+\Delta kx,\frac{\pi}{a}+\Delta ky\right) \quad \cdots \ (8)$$

[Equation 9]

$$K2=\left(-\frac{\pi}{a}+\Delta kx,\frac{\pi}{a}+\Delta ky\right) \quad \cdots \ (9)$$

[Equation 10]

$$K3=\left(-\frac{\pi}{a}+\Delta kx,-\frac{\pi}{a}+\Delta ky\right) \quad \cdots \ (10)$$

[Equation 11]

$$K4=\left(\frac{\pi}{a}+\Delta kx,-\frac{\pi}{a}+\Delta ky\right) \quad \cdots \ (11)$$

Spreads $\Delta kx$ and $\Delta ky$ of the wave vectors satisfy the following equations (12) and (13), respectively. The maximum value $\Delta kx_{max}$ of the spread in the x-axis direction and the maximum value $\Delta ky_{max}$ of the spread in the y-axis direction of the in-plane wave vector are defined by the angular spread of the designed optical image.
[Equation 12]

$$-\Delta kx_{max} \leq \Delta kx \leq \Delta kx_{max} \quad \cdots \ (12)$$

[Equation 13]

$$-\Delta ky_{max} \leq \Delta ky \leq \Delta ky_{max} \quad \cdots \ (13)$$

When the diffraction vector V1 is expressed as in the following equation (14), the in-plane wave vectors K1 to K4 after the diffraction vector V1 is added become the following equations (15) to (18).
[Equation 14]

$$V=\left(Vx,Vy\right) \quad \cdots \ (14)$$

[Equation 15]

$$K1=\left(\frac{\pi}{a}+\Delta kx+Vx,\frac{\pi}{a}+\Delta ky+Vy\right) \quad \cdots \ (15)$$

[Equation 16]

$$K2=\left(-\frac{\pi}{a}+\Delta kx+Vx,\frac{\pi}{a}+\Delta ky+Vy\right) \quad \cdots \ (16)$$

[Equation 17]

$$K3 = \left( -\frac{\pi}{a} + \Delta kx + Vx, \; -\frac{\pi}{a} + \Delta ky + Vy \right) \quad \cdots \; (17)$$

[Equation 18]

$$K4 = \left( \frac{\pi}{a} + \Delta kx + Vx, \; -\frac{\pi}{a} + \Delta ky + Vy \right) \quad \cdots \; (18)$$

Considering that any of the in-plane wave vectors K1 to K4 falls within the light line LL in equations (15) to (18), the relationship of the following equation (19) holds.
[Equation 19]

$$\left( \pm\frac{\pi}{a} + \Delta kx + Vx \right)^2 + \left( \pm\frac{\pi}{a} + \Delta ky + Vy \right)^2 < \left( \frac{2\pi}{\lambda} \right)^2 \quad \cdots \; (19)$$

That is, by adding the diffraction vector V1 satisfying equation (19), any of the in-plane wave vectors K1 to K4 falls within the light line LL, and a part of +1st-order light and -1st-order light is output.

The reason why the size (radius) of the light line LL is set to $2\pi/\lambda$ is as follows. FIG. 39 is a diagram for schematically explaining a peripheral structure of the light line LL. The figure shows a boundary between a device and air in the Z direction. The magnitude of the wave vector of light in vacuum is $2\pi/\lambda$, but when light propagates in a device medium as shown in FIG. 39, the magnitude of a wave vector Ka in a medium with a refractive index n is $2\pi n/\lambda$. At this time, in order for light to propagate through the boundary between the device and air, wave components parallel to the boundary need to be continuous (law of conservation of wavenumber).

In FIG. 39, when the wave vector Ka and the Z axis form an angle $\theta$, the length of a wave vector Kb projected onto the plane (that is, in-plane wave vector) is $(2\pi n/\lambda)\sin\theta$. On the other hand, since the refractive index n of the medium is generally larger than 1, the law of conservation of wavenumber does not hold at an angle where the in-plane wave vector Kb in the medium becomes larger than $2\pi/\lambda$. At this time, light is totally reflected and cannot be extracted to the air side. The magnitude of the wave vector corresponding to this total reflection condition is the magnitude of the light line LL, that is, $2\pi/\lambda$.

As an example of a specific method for adding the diffraction vector V1 to the in-plane wave vectors K1 to K4, a method of superimposing a phase distribution $\phi_2(x, y)$ irrelevant to the desired emission light shape on a phase distribution $\phi_1(x, y)$ corresponding to the desired emission light shape is conceivable. In this case, the phase distribution $\phi(x, y)$ of the phase modulation layer 15 (first region 151 and second region 152) is expressed as $\phi(x, y) = \phi_1(x, y) + \phi_2(x, y)$. $\phi_1(x, y)$ corresponds to the phase of the complex amplitude when the desired shape of the emitted light is Fourier transformed as described above. Further, $\phi_2(x, y)$ is a phase distribution for adding the diffraction vector V1 satisfying the above equation (19).

FIG. 40 is a diagram conceptually showing an example of the phase distribution $\phi_2(x, y)$. In the example of the figure, a first phase value $\phi_A$ and a second phase value $\phi_B$ having a value different from the first phase value $\phi_A$ are arranged in a checkered pattern. In one example, the phase value $\phi_A$ is 0 (rad), and the phase value $\phi_B$ is $\pi$(rad). In this case, the first phase value $\phi_A$ and the second phase value $\phi_B$ change by $\pi$. With such an arrangement of phase values, the diffraction vector V1 along the $\Gamma$-M1 axis or the $\Gamma$-M2 axis can be suitably realized. In the case of the checkered pattern arrangement, $V1 = (\pm\pi/a, \pm\pi/a)$, and the diffraction vector V1 and any one of the in-plane wave vectors K1 to K4 in FIG. 9 exactly cancel each other out. Therefore, the symmetry axis of +1st-order light and -1st-order light coincides with the Z direction, that is, the direction perpendicular to the in-plane direction of the phase modulation layer 15. Generally, an angular distribution $\theta_2(x, y)$ of a diffraction vector V is represented by an inner product of the diffraction vector V(Vx, Vy) and a position vector r(x, y), and is given by the following equation.

$$\theta_2(x, y) = V \cdot r = Vx \cdot x + Vy \cdot y$$

Therefore, in the case of V = V1, if the position vector is r(xa, ya) (x and y are both integers), the phase values become 0 and $\pi$. On the other hand, as described above, the diffraction vector V1 may be shifted from $(\pm\pi/a, \pm\pi/a)$ as long as at least one of the in-plane wave vectors K1 to K4 falls within the light line LL.

In the present embodiment, when the wavenumber spread based on the angular spread of the emitted light is included in a circle with a radius Δk centered on a certain point in the wavenumber space, it can be simply considered as follows. By adding the diffraction vector V1 to the in-plane wave vectors K1 to K4 in four directions, the magnitude of at least one of the in-plane wave vectors K1 to K4 in four directions is made smaller than 2π/λ (light line LL). This can be considered as making the magnitude of at least one of the in-plane wave vectors K1 to K4 in four directions smaller than a value {(2π/λ) - Δk} obtained by subtracting the wavenumber spread Δk from 2π/λ by adding the diffraction vector V1 to the in-plane wave vectors K1 to K4 in four directions from which the wavenumber spread Δk is removed.

FIG. 41 is a diagram conceptually showing the above idea. As shown in the figure, when the diffraction vector V1 is added to the in-plane wave vectors K1 to K4 excluding the wavenumber spread Δk, the magnitude of at least one of the in-plane wave vectors K1 to K4 becomes smaller than {(2π/λ) - Δk}. In FIG. 12, a region LL2 is a circular region with a radius of {(2π/λ) - Δk}. In FIG. 41, in-plane wave vectors K1 to K4 shown by broken lines represent those before addition of the diffraction vector V1, and in-plane wave vectors K1 to K4 shown by solid lines represent those after addition of the diffraction vector V1. The region LL2 corresponds to a total reflection condition considering the wavenumber spread Δk, and a wave vector having a magnitude contained within the region LL2 propagates also in the plane vertical direction (Z-axis direction).

In this embodiment, the magnitude and direction of the diffraction vector V1 for containing at least one of the in-plane wave vectors K1 to K4 within the region LL2 will be described. The following equations (20) to (23) show the in-plane wave vectors K1 to K4 before the diffraction vector V1 is added.

[Equation 20]

$$K1 = \left( \frac{\pi}{a}, \frac{\pi}{a} \right) \quad \cdots \quad (20)$$

[Equation 21]

$$K2 = \left( -\frac{\pi}{a}, \frac{\pi}{a} \right) \quad \cdots \quad (21)$$

[Equation 22]

$$K3 = \left( -\frac{\pi}{a}, -\frac{\pi}{a} \right) \quad \cdots \quad (22)$$

[Equation 23]

$$K4 = \left( \frac{\pi}{a}, -\frac{\pi}{a} \right) \quad \cdots \quad (23)$$

Here, when the diffraction vector V1 is expressed as in the above-described equation (14), the in-plane wave vectors K1 to K4 after the diffraction vector V1 is added become the following equations (24) to (27).

[Equation 24]

$$K1 = \left( \frac{\pi}{a} + Vx, \frac{\pi}{a} + Vy \right) \quad \cdots \quad (24)$$

[Equation 25]

$$K2 = \left( -\frac{\pi}{a} + Vx, \frac{\pi}{a} + Vy \right) \quad \cdots \quad (25)$$

[Equation 26]

$$K3 = \left( -\frac{\pi}{a} + Vx, \ -\frac{\pi}{a} + Vy \right) \quad \cdots \ (26)$$

[Equation 27]

$$K4 = \left( \frac{\pi}{a} + Vx, \ -\frac{\pi}{a} + Vy \right) \quad \cdots \ (27)$$

Considering that any of the in-plane wave vectors K1 to K4 falls within the region LL2 in equations (24) to (27), the relationship of the following equation (28) holds. That is, by adding the diffraction vector V1 satisfying equation (28), any of the in-plane wave vectors K1 to K4 excluding the wavenumber spread $\triangle$ k falls within the region LL2. Even in such a case, a part of +1st-order light and -1 st-order light can be output without outputting zero-order light.
[Equation 28]

$$\left( \pm\frac{\pi}{a} + Vx \right)^2 + \left( \pm\frac{\pi}{a} + Vy \right)^2 < \left( \frac{2\pi}{\lambda} - \Delta k \right)^2 \quad \cdots \ (28)$$

FIG. 42 is a plan view showing another form of the phase modulation layer 15 (first region 151 and second region 152). FIG. 43 is a diagram showing an arrangement of different refractive index regions 15b in the phase modulation layer 15 (first region 151 and second region 152) shown in FIG. 42. As shown in FIGS. 42 and 43, the center of gravity G of each different refractive index region 15b of the phase modulation layer 15 may be arranged on a straight line D. The straight line D is a straight line passing through the lattice point O corresponding to each unit configuration region R and inclined with respect to each side of the square lattice. That is, the straight line D is a straight line inclined with respect to both the X axis and the Y axis. An inclination angle of the straight line D with respect to one side (X axis) of the square lattice is β.

In this case, the inclination angle β is constant in the phase modulation layer 15 (first region 151 and second region 152). The inclination angle β satisfies 0° < β < 90°, and in one example, β = 45°. Alternatively, the inclination angle β satisfies 180° < β < 270°, and in one example, β = 225°. When the inclination angle β satisfies 0° < β < 90° or 180° < β < 270°, the straight line D extends from the first quadrant to the third quadrant of the coordinate plane defined by the X axis and the Y axis. The inclination angle β satisfies 90° < β < 180°, and in one example, β = 135°. Alternatively, the inclination angle β satisfies 270° < β < 360°, and in one example, β = 315°. When the inclination angle β satisfies 90° < β < 180° or 270° < β < 360°, the straight line D extends from the second quadrant to the fourth quadrant of the coordinate plane defined by the X axis and the Y axis. Thus, the inclination angle β is an angle excluding 0°, 90°, 180°, and 270°.

Here, the distance between the lattice point O and the center of gravity G is defined as r(x, y). x is the position of the x-th lattice point on the X axis, and y is the position of the y-th lattice point on the Y axis. When the distance r(x, y) is a positive value, the center of gravity G is located in the first quadrant (or the second quadrant). When the distance r(x, y) is a negative value, the center of gravity G is located in the third quadrant (or the fourth quadrant). When the distance r(x, y) is 0, the lattice point O and the center of gravity G coincide with each other. The inclination angle is preferably 45°, 135°, 225°, or 275°. At these inclination angles, only two of the four wave vectors forming the standing wave at the M point (for example, in-plane wave vectors ($\pm\pi$/a, $\pm\pi$/a)) are phase-modulated, and the other two are not phase-modulated, so that a stable standing wave can be formed.

The distance r(x, y) between the center of gravity G of each different refractive index region and the lattice point O corresponding to each unit configuration region R is individually set for each different refractive index region 15b according to the phase distribution $\phi$(x, y) corresponding to the desired emission light shape. In the present disclosure, such an arrangement form of the center of gravity G is referred to as a second form. The phase distribution $\phi$(x, y) and the distance distribution r(x, y) have specific values for each position determined by the values of x and y, but are not necessarily represented by a specific function. The distribution of the distance r(x, y) is determined from one obtained by extracting the phase distribution $\phi$(x, y) from the complex amplitude distribution obtained by inverse Fourier transforming the desired emission light shape.

That is, when the phase $\phi$(x, y) at a certain coordinate (x, y) is $\phi_0$, the distance r(x, y) is set to 0, when the phase $\phi$(x, y) is $\pi + \phi_0$, the distance r(x, y) is set to the maximum value R0, and when the phase $\phi$(x, y) is $-\pi + \phi_0$, the distance r(x, y) is set to the minimum value $-R_0$. Then, for an intermediate phase $\phi$(x, y), the distance r(x, y) is taken such that r(x, y) = {$\phi$(x, y) - $\phi_0$} $\times R_0/\pi$. The initial phase $\phi_0$ can be set arbitrarily.

When the lattice spacing of the virtual square lattice is a, the maximum value R0 of r(x, y) falls within the range of the following equation (29), for example. When obtaining the complex amplitude distribution from the desired optical image, it is possible to improve the reproducibility of the beam pattern by applying an iterative algorithm such as the GS method generally used when calculating hologram generation.

[Equation 29]

$$0 \leq R_0 \leq \frac{a}{\sqrt{2}} \qquad \cdots \quad (2\,9)$$

In this second form, a desired light emission shape (number of condensing points, position, etc.) can be obtained by determining the distribution of the distance r(x, y) of the different refractive index regions 15b of the phase modulation layer 15 (first region 151 and second region 152). Under the first to fourth preconditions similar to those of the first form described above, the phase modulation layer 15 (first region 151 and second region 152) is configured to satisfy the following conditions. That is, the corresponding different refractive index region 15b is arranged in the unit configuration region R(x, y) such that the distance r(x, y) from the lattice point O(x, y) to the center of gravity G of the corresponding different refractive index region 15b satisfies the following relationship. When it is desired to obtain a desired light emission shape, it is preferable to inverse Fourier transform the light emission shape and give a distribution of distance r(x, y) corresponding to the phase $\phi$(x, y) of its complex amplitude to the plurality of different refractive index regions 15b. The phase $\phi$(x, y) and the distance r(x, y) may be proportional to each other.

$$r(x, y) = C \times (\phi(x, y) - \phi_0)$$

C: Proportional constant, for example, $R_0/\pi$
$\phi_0$: Arbitrary constant, for example, 0

Also in this second form, by applying the following contrivance to the phase modulation layer 15 (first region 151 and second region 152) in the light emitting device oscillating at the M point, a part of +1st-order light and -1st-order light is output without outputting zero-order light into the light line LL. Specifically, as shown in FIG. 38, by adding a diffraction vector V1 having a certain magnitude and direction to the in-plane wave vectors K1 to K4, the magnitude of at least one of the in-plane wave vectors K1 to K4 is made smaller than $2\pi/\lambda$. That is, at least one of the in-plane wave vectors K1 to K4 after the diffraction vector V1 is added is contained within the light line LL which is a circular region with a radius of $2\pi/\lambda$. By adding the diffraction vector V1 satisfying the above-described equation (19), any of the in-plane wave vectors K1 to K4 falls within the light line LL, and a part of +1st-order light and -1st-order light is output.

Alternatively, as shown in FIG. 41, by adding the diffraction vector V1 to the in-plane wave vectors K1 to K4 in four directions from which the wavenumber spread $\Delta$k is removed (that is, in-plane wave vectors in four directions in the square lattice PCSEL of M-point oscillation), the magnitude of at least one of the in-plane wave vectors K1 to K4 in four directions may be made smaller than a value $\{(2\pi/\lambda) - \Delta k\}$ obtained by subtracting the wavenumber spread $\Delta$k from $2\pi/\lambda$. That is, by adding the diffraction vector V1 satisfying the above-described equation (28), any of the in-plane wave vectors K1 to K4 falls within the region LL2, and a part of +1st-order light and -1 st-order light is output.

As described above, in the light extraction region 15P, light emitted from the active layer 12 and resonating in the in-plane direction of the XY plane in the phase modulation layer 15 is diffracted in the out-of-plane direction of the XY plane (direction intersecting the XY plane) in the first region 151 and the second region 152, and a part of +1st-order light and -1st-order light is output only from the first region 151 and the second region 152. Thereby, as shown in FIG. 15, in the phase modulation layer 15, a pseudo double slit using each of the first region 151 and the second region 152 as a slit is formed, and interference fringes due to interference of emitted light can be formed in the Fresnel region.

**Reference Signs List**

1, 1A: Laser measurement device, 2: Flow cell (flow path device), 3, 3A to 3D, 31, 32: Surface-emitting laser (light source, light source unit), 3a: Light emission surface, 4, 4A, 4B: Photodetector (sensor), 15, 15A: Phase modulation layer, 15a: Base layer, 15b: Different refractive index region, 21: Sample flow path, 22: Side wall, L1: Laser light, L2: Emitted light, P, P1, P2, PC, PD, PM1, PM2: Beam pattern, PA: Beam pattern (first beam pattern), PB: Beam pattern (second beam pattern), Pa, PAa, PBa: Bright part, Pb: Dark part, Ra: Passing region, S, Sa to Sm: Sample (particle).

**Claims**

1. A laser measurement device comprising:

   a flow path device including a sample flow path through which a fluid containing a particle to be measured passes;
   a light source that emits laser light toward the sample flow path, wherein the laser light has a beam pattern in which at least two bright parts are arranged with a dark part interposed therebetween along a flow direction of the fluid; and
   a sensor that detects emitted light emitted from the particle when the particle passes through a region where the beam pattern is formed in the sample flow path.

2. The laser measurement device according to claim 1, wherein the light source has a surface-emitting laser configured to include:

   a light emitting unit; and
   a phase modulation layer optically coupled to the light emitting unit and including a base layer and a plurality of different refractive index regions having a refractive index different from that of the base layer.

3. The laser measurement device according to claim 2, wherein a center of gravity of each of the plurality of different refractive index regions is arranged at a relative position according to a phase distribution corresponding to the beam pattern with respect to each of a plurality of lattice points arranged periodically.

4. The laser measurement device according to claim 2,

   wherein the phase modulation layer is a photonic crystal layer in which the plurality of different refractive index regions are arranged periodically, and
   the light source further has a slit member that forms the laser light having the beam pattern by passing light emitted from the surface-emitting laser.

5. The laser measurement device according to claim 1, wherein the light source has:

   a vertical cavity surface-emitting laser; and
   a slit member that forms the laser light having the beam pattern by passing light emitted from the surface-emitting laser.

6. The laser measurement device according to any one of claims 1 to 5, wherein the light source is fixed to a side wall of the flow path device.

7. The laser measurement device according to any one of claims 1 to 6, wherein the light source forms a striped beam pattern in which a plurality of the bright parts extending in a direction intersecting the flow direction are arranged along the flow direction.

8. The laser measurement device according to claim 7,

   wherein the light source has a surface-emitting laser configured to include a light emitting unit and a phase modulation layer optically coupled to the light emitting unit and including a base layer and a plurality of different refractive index regions having a refractive index different from that of the base layer, and
   the surface-emitting laser forms the striped beam pattern by causing lights emitted from respective ones of a plurality of regions different from each other in an in-plane direction of a light emission surface of the surface-emitting laser to interfere with each other.

9. The laser measurement device according to any one of claims 1 to 8, wherein the light source includes a plurality of light source units arranged along the flow direction.

10. The laser measurement device according to any one of claims 1 to 8, wherein the light source includes a plurality of light source units arranged along a direction intersecting the flow direction.

11. The laser measurement device according to claim 9 or 10,

wherein each of the plurality of light source units is configured to form, in the sample flow path, a striped beam pattern in which a plurality of the bright parts extending in a direction intersecting the flow direction are arranged at predetermined intervals along the flow direction, and

in a passing region through which the particle passes in the sample flow path, the beam patterns of each of the plurality of light source units are arranged so as not to overlap each other.

12. The laser measurement device according to claim 9 or 10, wherein the plurality of light source units form a first bright part having a first intensity of brightness in a region of a first range in a first direction intersecting the flow direction, and form a second bright part having a second intensity of brightness different from the first intensity in a region of a second range different from the first range in the first direction.

13. The laser measurement device according to any one of claims 1 to 12,

wherein the light source includes a first light source unit that emits the laser light of a first wavelength, and a second light source unit that emits the laser light of a second wavelength different from the first wavelength, and the sensor detects a first signal corresponding to first emitted light emitted in response to the particle being irradiated with the laser light of the first wavelength, and a second signal corresponding to second emitted light emitted in response to the particle being irradiated with the laser light of the second wavelength.

14. The laser measurement device according to claim 13,

wherein the first light source unit forms a striped beam pattern in which a plurality of the bright parts extending in a direction intersecting the flow direction are arranged at a first interval along the flow direction, and the second light source unit forms a striped beam pattern in which a plurality of the bright parts extending in a direction intersecting the flow direction are arranged at a second interval different from the first interval along the flow direction.

15. The laser measurement device according to claim 13, wherein a first beam pattern formed by the first light source unit and a second beam pattern formed by the second light source unit have the same shape, and are arranged at positions shifted from each other along the flow direction.

16. The laser measurement device according to claim 13, wherein a pattern shape of a first beam pattern formed by the first light source unit is different from a pattern shape of a second beam pattern formed by the second light source unit.

17. The laser measurement device according to claim 13,

wherein the first light source unit forms a striped beam pattern in which a plurality of the bright parts extending in a first direction intersecting the flow direction are arranged along the flow direction, and the second light source unit forms a striped beam pattern in which a plurality of the bright parts extending in a second direction intersecting the first direction are arranged along the flow direction.

18. The laser measurement device according to any one of claims 1 to 17, wherein the light source temporally modulates an intensity of the laser light.

19. A laser measurement method using the laser measurement device according to any one of claims 1 to 18, comprising:

a step of forming a beam pattern in which at least two bright parts are arranged with a dark part interposed therebetween along a flow direction of a fluid in a sample flow path through which the fluid containing a particle to be measured passes in the flow path device, by emitting the laser light from the light source to the flow path device; a step of detecting emitted light emitted from the particle when the particle passes through a region where the beam pattern is formed; and a step of determining at least one of a shape and a size of the particle based on the detected emitted light.

# Fig.1

*Fig.2*

# Fig.3

# Fig.4

S

Y
Z
X

## Fig.5

# Fig.6

LIGHT OUTPUT

**Fig.7**

EP 4 772 857 A1

# *Fig.8*

**Fig.9**

**Fig.10**

EP 4 772 857 A1

**Fig.11**

*Fig.12*

# *Fig.13*

(A)

(B)

(C)

(D)

**Fig.14**

EP 4 772 857 A1

## Fig.15

Fig.16

Fig.17

Fig.18

EP 4 772 857 A1

## Fig.19

(A)

(B)

# Fig.20

EP 4 772 857 A1

# Fig.21

Fig.22

Fig.23

*Fig.24*

Fig.25

## Fig.26

(A)

(B)

*Fig.27*

DETECTOR OUTPUT

TIME

Rb

Fig.28

# Fig.29

*Fig.30*

*Fig.31*

*Fig.32*

(A)

PM1
Pa
21
C
X
Z
Y

(B)

PM2
Pa
21
X
Z
Y

# Fig.33

LIGHT OUTPUT

*Fig.34*

LIGHT OUTPUT

Fig.35

## Fig.36

## Fig.37

# Fig.38

*Fig.39*

*Fig.40*

| $\varphi_A$ | $\varphi_B$ | $\varphi_A$ | $\varphi_B$ | $\varphi_A$ | $\varphi_B$ |
|---|---|---|---|---|---|
| $\varphi_B$ | $\varphi_A$ | $\varphi_B$ | $\varphi_A$ | $\varphi_B$ | $\varphi_A$ |
| $\varphi_A$ | $\varphi_B$ | $\varphi_A$ | $\varphi_B$ | $\varphi_A$ | $\varphi_B$ |
| $\varphi_B$ | $\varphi_A$ | $\varphi_B$ | $\varphi_A$ | $\varphi_B$ | $\varphi_A$ |
| $\varphi_A$ | $\varphi_B$ | $\varphi_A$ | $\varphi_B$ | $\varphi_A$ | $\varphi_B$ |
| $\varphi_B$ | $\varphi_A$ | $\varphi_B$ | $\varphi_A$ | $\varphi_B$ | $\varphi_A$ |

# Fig.41

Fig.42

# *Fig.43*

## INTERNATIONAL SEARCH REPORT

| International application No. |
|---|
| **PCT/JP2024/028106** |

**A. CLASSIFICATION OF SUBJECT MATTER**

*G01N 15/1434*(2024.01)i; *G01N 15/1429*(2024.01)i; *G01N 21/05*(2006.01)i; *G01N 21/49*(2006.01)i; *G01N 21/64*(2006.01)i; *H01S 5/02255*(2021.01)i; *H01S 5/11*(2021.01)i; *H01S 5/183*(2006.01)i; *H01S 5/185*(2021.01)i

FI: G01N15/1434; G01N15/1429 200; G01N15/1434 100; G01N21/05; G01N21/49 Z; G01N21/64 B; H01S5/02255; H01S5/11; H01S5/183; H01S5/185

According to International Patent Classification (IPC) or to both national classification and IPC

**B. FIELDS SEARCHED**

Minimum documentation searched (classification system followed by classification symbols)

G01N15/1434; G01N15/1429; G01N21/05; G01N21/49; G01N21/64; H01S5/02255; H01S5/11; H01S5/183; H01S5/185

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2015-152594 A (PALO ALTO RESEARCH CENTER INCORPORATED) 24 August 2015 (2015-08-24) | 1-19 |
| A | JP 2008-512683 A (HONEYWELL INTERNATIONAL, INC.) 24 April 2008 (2008-04-24) | 1-19 |
| A | JP 08-292145 A (CHEMUNEX) 05 November 1996 (1996-11-05) | 1-19 |
| A | JP 2013-504051 A (RADISENS DIAGNOSTICS LIMITED) 04 February 2013 (2013-02-04) | 1-19 |
| A | WO 2019/116802 A1 (HORIBA, LTD.) 20 June 2019 (2019-06-20) | 1-19 |

☐ Further documents are listed in the continuation of Box C.    ☑ See patent family annex.

\* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 September 2024** | **08 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/028106**

| Patent document cited in search report | | | Publication date (day/month/year) | Patent family member(s) | | | Publication date (day/month/year) |
|---|---|---|---|---|---|---|---|
| JP | 2015-152594 | A | 24 August 2015 | US | 2015/0233703 | A1 | |
| | | | | EP | 2908117 | A2 | |
| JP | 2008-512683 | A | 24 April 2008 | US | 6549275 | B1 | |
| | | | | WO | 2002/010714 | A2 | |
| | | | | CN | 1688865 | A | |
| JP | 08-292145 | A | 05 November 1996 | US | 5891394 | A | |
| | | | | EP | 713087 | A1 | |
| JP | 2013-504051 | A | 04 February 2013 | US | 2012/0156714 | A1 | |
| | | | | WO | 2011/026942 | A2 | |
| | | | | EP | 2293032 | A1 | |
| WO | 2019/116802 | A1 | 20 June 2019 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022077967 A

- JP 2022154929 A

**Non-patent literature cited in the description**

- **Y. KUROSAKA et al.** Effects of non-lasing band in two-dimensional photonic-crystal lasers clarified using omnidirectional band structure. *Opt. Express*, 2012, vol. 20, 21773-21783